# EUROPEAN PATENT APPLICATION

(11) **EP 4 729 960 A1**
(43) Date of publication of application: **22.04.2026**
(21) Application number: 25186054.0
(22) Date of filing: 27.06.2025
(51) Int. Cl.: G01R 31/367, G01R 31/3842, G01R 31/396, H01M 10/48, H02J 7/00

(54) **ELECTRIC DEVICE AND METHOD FOR OPERATING ELECTRIC DEVICE FOR CALCULATING INTEGRATED STATE OF CHARGE FOR BATTERY PACK**

(30) Priority: 17.10.2024 KR 20240141820
(71) Applicant: Samsung Electronics Co., Ltd., Suwon-si, Gyeonggi-do 16677 (KR)
(72) Inventor: SEO, Minhwan, 16677 Suwon-si (KR); MOON, Sangbin, 16677 Suwon-si (KR); PARK, Hyukrae, 16677 Suwon-si (KR); SEO, Jeonghun, 16677 Suwon-si (KR); HEO, Jungwook, 16677 Suwon-si (KR)
(74) Representative: Marks & Clerk LLP

(57) **Abstract**

A method of operating an electronic device including a battery pack that includes a first battery cell and a second battery cell connected in parallel, includes calculating a first discharge relative state of charge (RSOC) value for the first battery cell, based on a state of charge (SOC) value of the first battery cell that is calculated based on one or more of a voltage or a current of the first battery cell, calculating a second discharge RSOC value for the second battery cell, based on a SOC value of the second battery cell that is calculated based on one or more of a voltage or a current of the second battery cell, and calculating integrated SOC data for the battery pack based on the first discharge RSOC value and the second discharge RSOC value.

## Description

### BACKGROUND

The present disclosure relates to an electronic device for calculating an integrated state of charge of a battery pack and a method of operating the electronic device.

In electronic devices equipped with a lithium ion battery, a state of charge (SOC) value of the battery may be calculated by an Electro-Chemical Thermal Model (ECT) method or an Equivalent Circuit Model (ECM) method. The actual SOC value of the battery may be calculated as being sharply increased or decreased, but the user of the electronic device may misunderstand that the battery is defective if the SOC value of the battery displayed on the display panel sharply increases or decreases. Accordingly, research is being conducted to improve the reliability of batteries and battery-equipped electronic devices from the user's perspective by correcting the SOC value of the battery.

### SUMMARY

It is an aspect to provide an electronic device and a method of operating an electronic device capable of accurately and reliably calculating the integrated SOC of a battery pack in which a plurality of battery cells are connected in parallel.

According to an aspect of one or more example embodiments, there is provided a method of operating an electronic device comprising a battery pack comprising a first battery cell and a second battery cell connected in parallel, the method performed by a micro controller unit and comprising calculating a first discharge relative state of charge (RSOC) value for the first battery cell, based on a state of charge (SOC) value of the first battery cell that is calculated based on at least one of a voltage or a current of the first battery cell; calculating a second discharge RSOC value for the second battery cell, based on a SOC value of the second battery cell that is calculated based on at least one of a voltage or a current of the second battery cell; and calculating integrated SOC data for the battery pack based on the first discharge RSOC value and the second discharge RSOC value.

According to another aspect of one or more example embodiments, there is provided an electronic device comprising a battery pack comprising a first battery cell and a second battery cell connected in parallel, the battery pack configured to supply power to the electronic device; a sensing device configured to sense at least one of a voltage or a current of the first battery cell and at least one of a voltage or a current of the second battery cell; and a microcontroller unit (MCU) configured to implement a state of charge (SOC) calculation unit configured to calculate a SOC value of the first battery cell based on the at least one of the voltage or the current of the first battery cell and calculate a SOC value of the second battery cell based on the at least one of the voltage or the current of the second battery cell; and an integrated SOC calculation unit configured to calculate a first discharge state of charge (RSOC) value for the first battery cell based on the SOC value of the first battery cell, calculate a second discharge RSOC value for the second battery cell based on the SOC value of the second battery cell, and calculate integrated SOC data for the battery pack based on the first discharge RSOC value and the second discharge RSOC value.

According to yet another aspect of one or more example embodiments, there is provided an electronic device comprising a battery pack comprising a first battery cell and a second battery cell connected in parallel, the battery pack configured to supply power to the electronic device; a sensing device configured to sense at least one of a voltage or a current of the first battery cell and at least one of a voltage or a current of the second battery cell; a micro controller unit (MCU) configured to implement a state of charge (SOC) calculation unit configured to calculate a SOC value of the first battery cell based on the at least one of the voltage or the current of the first battery cell and calculate a SOC value of the second battery cell based on the at least one of the voltage or the current of the second battery cell; and an integrated SOC calculation unit configured to generate integrated SOC data; a display; and a processor configured to receive the integrated SOC data, convert the integrated SOC data into a remaining battery capacity, and control the display to display the remaining battery capacity. The integrated SOC calculation unit is configured to determine a state of the battery pack as one state among a discharge state, a charge state, and an idle state, based on at least one of the current of the first battery cell, the voltage of the first battery cell, the current of the second battery cell, or the voltage of the second battery cell; calculate a first discharge state of charge (RSOC) value for the first battery cell, based on the SOC value of the first battery cell; calculate a second discharge RSOC value for the second battery cell, based on the SOC value of the second battery cell; calculate a first integrated SOC value for the battery pack that is determined to be in the discharge state, the first integrated SOC value being based on the first discharge RSOC value and the second discharge RSOC value; calculate a first charge RSOC value for the first battery cell, based on the SOC value of the first battery cell; calculate a second charge RSOC value for the second battery cell, based on the SOC value of the second battery cell; and calculate a second integrated SOC value for the battery pack that is determined to be in the charge state, the second integrated SOC value being based on the first charge RSOC value and the second charge RSOC value; and the integrated SOC calculation unit is configured to generate the integrated SOC data based on the first integrated SOC value and the second integrated SOC value.

At least some of the above and other features of the invention are set out in the claims.

### BRIEF DESCRIPTION OF THE DRAWINGS

The above and other aspects will become more apparent by describing in detail example embodiments thereof with reference to the attached drawings, in which:
FIG. 1 is a block diagram illustrating an electronic device according to some embodiments;
FIG. 2 is a block diagram illustrating an example of an integrated state of charge (SOC) calculation unit according to an embodiment;
FIG. 3 is a flowchart illustrating an example of a method of operating an electronic device according to an embodiment;
FIG. 4 is a flowchart for explaining a battery state determination unit according to an embodiment;
FIG. 5 is a flowchart for explaining a discharge RSOC calculation unit according to an embodiment;
FIG. 6 is a graph for explaining discharge RSOC values according to an embodiment;
FIG. 7 is a flowchart for explaining a charge RSOC calculation unit according to an embodiment;
FIG. 8 is a graph for explaining a charge RSOC value according to an embodiment;
FIG. 9 is a flowchart for explaining a function mapping unit according to an embodiment;
FIG. 10 is a graph for explaining a first mapping SOC value according to an embodiment;
FIG. 11 is a flowchart for explaining a function mapping unit according to an embodiment;
FIG. 12 is a graph for explaining a second mapping SOC value according to an embodiment;
FIG. 13 is a flowchart for explaining a correction filter application unit according to an embodiment;
FIG. 14 is a flowchart for explaining a correction filter application unit according to an embodiment;
FIGS. 15 and 16 are graphs for explaining integrated SOC data to which a correction filter is applied according to an embodiment;
FIG. 17 is a graph showing specification information of a battery pack according to an embodiment;
FIG. 18 is a charge/discharge graph of a battery pack according to an embodiment;
FIG. 19 is a graph showing specification information of a battery pack according to an embodiment; and
FIG. 20 is a charge/discharge graph of a battery pack according to an embodiment.

### DETAILED DESCRIPTION

According to various embodiments described below, a user may intuitively determine a remaining capacity of power of an electronic device.

According to various embodiments described below, an improved integrated state of charge may be provided for a battery pack including a plurality of battery cells connected in parallel.

According to various embodiments described below, the values of the integrated SOC data may fluctuate gradually without exhibiting abrupt changes. As the remaining battery capacity, which is displayed after converting the integrated SOC data, does not fluctuate drastically, it is possible to provide users with a high degree of predictability regarding the power supply of electronic devices.

As used in this specification, a phrase using the form "at least one of A, B, or C" includes within its scope "only A", "only B", "only C", "A and B", "A and C", "B and C" and "A, B, and C."

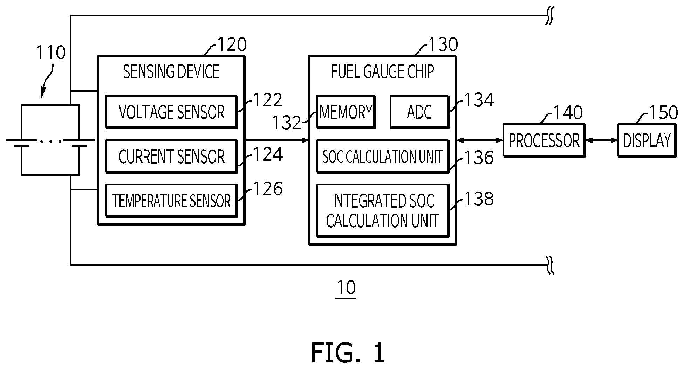

Hereinafter, various embodiments will be described with reference to FIGS. 1 to 20. Throughout the specification, the same reference numerals may refer to the same components and repeated description thereof may be omitted for conciseness.

FIG. 1 is a block diagram illustrating an electronic device 10 according to some embodiments. Referring to FIG. 1, an electronic device 10 may include a battery pack 110, a sensing device 120, a fuel gauge chip 130 (otherwise known as a power gauge chip or a charge gauge chip), a processor 140, and a display 150. However, embodiments are not limited to this example and, in some embodiments, the electronic device 10 may further include other components in addition to the illustrated components.

The battery pack 110 may generate a power voltage to supply power to the electronic device 10. The battery pack 110 may be charged by a power supply device connected to the electronic device 10. The battery pack 110 may include at least one battery cell.

For each of the at least one battery cell, a state of charge (SOC) value may be calculated as the remaining capacity. The SOC may be a percentile value that is the remaining capacity of a battery cell divided by the total capacity of the battery cell. That is, the SOC may have a value between 0% and 100%. The total capacity of a battery cell may mean the electric capacity of a fully charged battery cell minus the electric capacity of a fully discharged battery cell.

The sensing device 120 may include a voltage sensor 122, a current sensor 124, and a temperature sensor 126. The voltage sensor 122 may generate information about the voltage of the battery pack 110 or the voltage of the battery cells included in the battery pack 110. The voltage sensor 122 may measure the voltage across one or more (e.g. each) of the battery cells (e.g. between positive and negative terminals). The current sensor 124 may generate information about the current of the battery pack 110 or the current of the battery cells included in the battery pack 110. The current sensor 124 may measure the current to/from each of the battery cells (e.g. to/from a positive or negative terminal of each of the battery cells). The temperature sensor 126 may generate information about the temperature of the battery pack 110 or the temperature of the battery cells included in the battery pack 110. Thereafter, the sensing device 120 may transmit information about voltage, current, and temperature to a fuel gauge chip 130.

The fuel gauge chip 130 may include a memory 132, an analog-digital converter (ADC) 134, an SOC calculation unit 136, and an integrated SOC calculation unit 138. The memory 310 may be implemented as, for example, flash memory. Firmware for the operation of the fuel gauge chip 130, etc. may be stored in the memory 310. The ADC 134 may convert analog information (e.g., voltage, current, temperature, etc.), which is associated with the battery pack 110 or the battery cells included in the battery pack 110 received from the sensing device 120, into digital information. The ADC 134 may transmit digital information about voltage, current, and temperature to the SOC calculation unit 136. The SOC calculation unit 136 and the integrated SOC calculation unit 138 may be implemented by a microcontroller, such as a micro controller unit (MCU). The MCU may recognize digital information converted by the ADC 134. The operation of the MCU may be implemented in the form of software such as firmware, so that the operations of the SOC calculation unit 136 and the integrated SOC calculation unit 138 may perform many operations with relatively low power consumption. Because the operations of the SOC calculation unit 136 and the integrated SOC calculation unit 138 are performed independently from the processor 140, the burden on resource allocation and operation of the processor 140 may be reduced.

The SOC calculation unit 136 may calculate the SOC value of the battery cells included in a battery pack based on information about the voltage or current of the battery cell. The SOC calculation unit 136 may calculate the SOC value of the battery cells included in the battery pack based on information about voltage or current together with information about temperature. In an embodiment, the SOC calculation unit 136 may calculate the SOC value of the battery cell based on an Electro-Chemical Thermal Model (ECT). However, embodiments are not limited to this example. For example, the SOC calculation unit 136 may calculate the SOC of the battery cell based on a model-based method such as an equivalent circuit model (ECM) and/or a data-based learning model method.

The integrated SOC calculation unit 138 may calculate a discharge Relative SOC (RSOC) value for a battery cell based on the SOC value of the battery cell. The RSOC value may represent the ratio of the SOC value to a comparison SOC value. For example, the comparison SOC value may be determined as the SOC value for a battery cell in a fully charged state. In this case, the RSOC value may represent the ratio of the SOC value based on (e.g. with) the SOC value for a battery cell in a fully charged state. The comparison value may be predetermined.

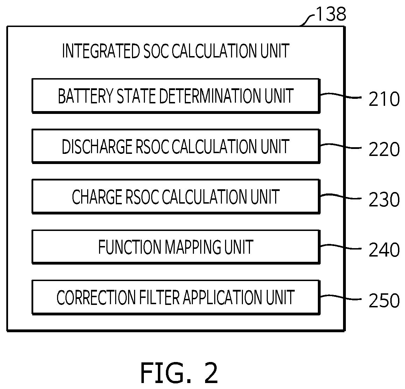

The integrated SOC calculation unit 138 may calculate a charge RSOC value for a battery cell based on the SOC value of the battery cell. The integrated SOC calculation unit 138 may calculate a first integrated SOC value for the battery pack 110 associated with the discharge state based on the discharge RSOC value. The integrated SOC calculation unit 138 may calculate a second integrated SOC value for the battery pack 110 associated with the charge state based on the charge RSOC value. The integrated SOC calculation unit 138 may generate integrated SOC data including a first integrated SOC value and a second integrated SOC value. The integrated SOC data may include integrated SOC values which are values equal to or greater than 0% and equal to or less than 100%. The configuration of the integrated SOC calculation unit 138 is described in detail with reference to FIG. 2.

The processor 140 may control the operation of the electronic device 10. For example, the processor 140 may control the operation of the electronic device 10 by performing basic arithmetic, logic, and input/output operations. For example, the processor 140 may control the operation of a battery pack 110, a sensing device 120, a fuel gauge chip 130, and a display 150 included in the electronic device 10. The processor 140 may receive integrated SOC data from the integrated SOC calculation unit 138 and convert the integrated SOC data into the remaining capacity of the battery. Here, the battery refers to a battery pack 110 that supplies power to the electronic device 10 or a battery cell included in the battery pack 110, and the remaining capacity of the battery may indicate information for guiding a user of the electronic device 10 about the amount of power that may be supplied to the electronic device 10. The processor 140 may output the remaining battery capacity to the display 150.

The display 150 may refer to any display device associated with the electronic device 10, and may be, for example, any display device capable of displaying any information/data controlled by the electronic device 10 or provided from the electronic device 10. For example, the display 150 may display the remaining battery capacity, allowing the user of the electronic device 10 to quantitatively determine the amount of power that may be supplied to the electronic device 10.

In an embodiment, the electronic device 10 may be a foldable device (e.g., a foldable smartphone, a foldable smart pad) that includes a plurality of parts. In this case, the battery cells included in the battery pack 110 may be disposed in various parts of the plurality of parts. For example, in an embodiment, a first battery cell of the battery pack 110 may be disposed in a first part and a second battery cell of the battery pack 110 may be disposed in a second part different from the first part, such as first and second halves of a foldable smartphone, etc.

FIG. 2 is a block diagram illustrating an example of an integrated SOC calculation unit 138 according to an embodiment. As discussed above, the integrated SOC calculation unit 138 may be structurally implemented by the fuel gauge chip 130 and more specifically by the MCU included therein. The integrated SOC calculation unit 138 may include a battery state determination unit 210, a discharge RSOC calculation unit 220, a charge RSOC calculation unit 230, a function mapping unit 240, and a correction filter application unit 250, each of which may be structurally implemented by the MCU of the fuel gauge chip 130. The configuration included in the integrated SOC calculation unit 138 may receive the SOC value of the battery cell calculated from the SOC calculation unit (e.g., the SOC calculation unit 136 of FIG. 1). The configuration included in the integrated SOC calculation unit 138 may receive information associated with a battery pack or battery cell generated by a sensing device (e.g., the sensing device 120 of FIG. 1). The internal configuration of the integrated SOC calculation unit 138 illustrated in FIG. 2 is only an example, and in an embodiment, other configurations may be additionally included in addition to the illustrated internal configuration, some configurations may be omitted, and some processes may be performed by other configurations or external systems.

An operation performed by one of the components included in the integrated SOC calculation unit 138 illustrated in FIG. 2 may also be performed by another one of the components included in the integrated SOC calculation unit 138. For example, the operation of determining the state of the battery pack may be performed by at least one of the battery state determination unit 210, the discharge RSOC calculation unit 220, the charge RSOC calculation unit 230, the function mapping unit 240, or the correction filter application unit 250. That is, although the internal components of the integrated SOC calculation unit 138 are explained by dividing them by function, this does not mean that the operations performed by the internal components are distinguished.

Hereinafter, a case where a maximum value of the SOC value (or RSOC value or remaining battery capacity) is 100% and a minimum value is 0% will be explained as an example. However, this is not limited to this example, and the maximum value and the minimum value of the SOC value (or RSOC value or remaining capacity of the battery) may differ depending on the embodiment. In some cases, the maximum value of the SOC value and the minimum value of the SOC value may each be predetermined.

Hereinafter, the case where the voltage of the battery pack is greater than or less than a comparison voltage may be explained separately, or the case where the voltage of the battery cell is greater than or less than a comparison voltage may be explained separately. It is possible to separately explain the case where the current of the battery pack is greater than or less than a comparison current, or the case where the voltage of the battery cell is greater than or less than a comparison voltage. However, embodiments are not limited to this example, and the case where the voltage (or current) is greater than the comparison voltage (or current) may also be applied to the case where the voltage or current is greater than or equal to the comparison voltage or current. Correspondingly, the case where the voltage or current is less than a comparison voltage or current may be similarly applied to the case where the voltage or current is less than or equal to the comparison voltage or current.

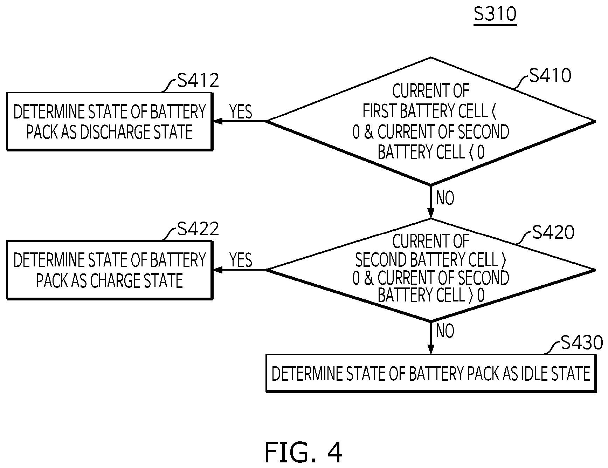

The battery state determination unit 210 may determine the state of the battery pack as one state among a discharge state, a charge state, and an idle state based on at least one of the current of the battery cells included in the battery pack or the voltage of the battery cells. That is, the state of the battery pack may be one of a discharge state, a charge state, or an idle state. The specific operation of the battery state determination unit 210 is described in detail with reference to FIG. 4.

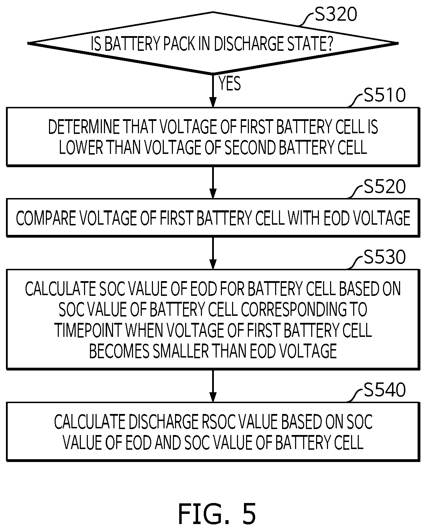

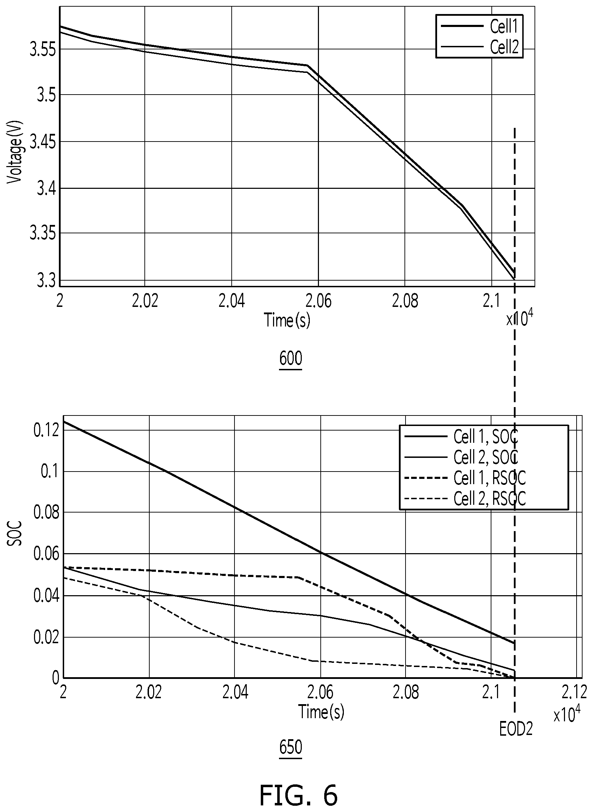

The discharge RSOC calculation unit 220 may calculate the discharge RSOC value for the battery cell based on the SOC value of the battery cell. The discharge RSOC calculation unit 220 may calculate a discharge RSOC value for each of at least one battery cell included in the battery pack. The specific operation of the discharge RSOC calculation unit 220 is described in detail with reference to FIGS. 5 and 6.

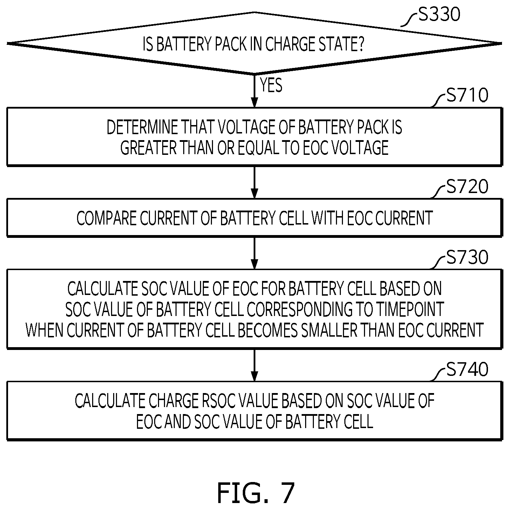

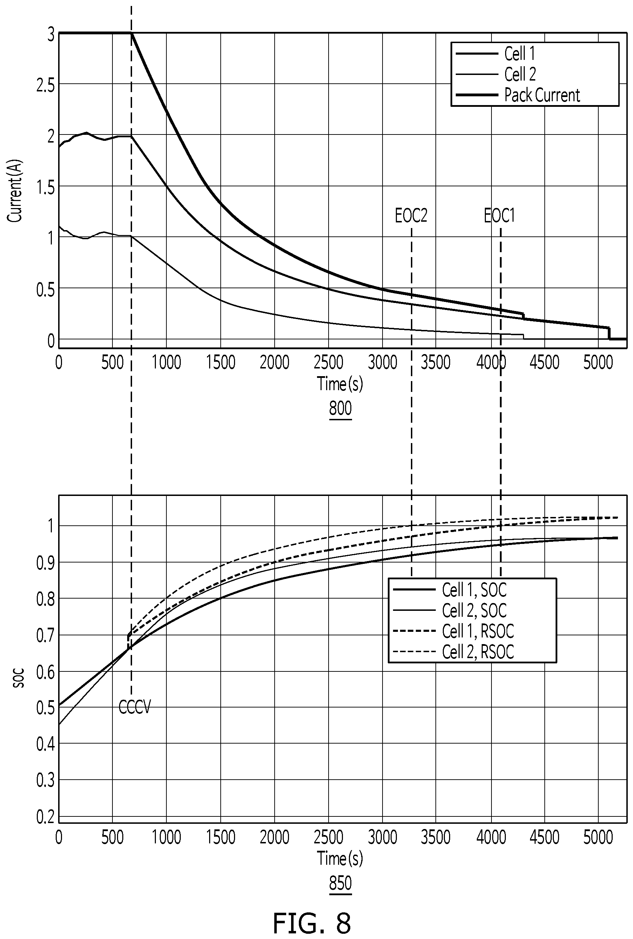

The charge RSOC calculation unit 230 may calculate the charge RSOC value for the battery cell based on the SOC value of the battery cell. The charge RSOC calculation unit 230 may calculate a charging RSOC value for each of at least one battery cell included in the battery pack. The specific operation of the charge RSOC calculation unit 230 is described in detail with reference to FIGS. 7 and 8.

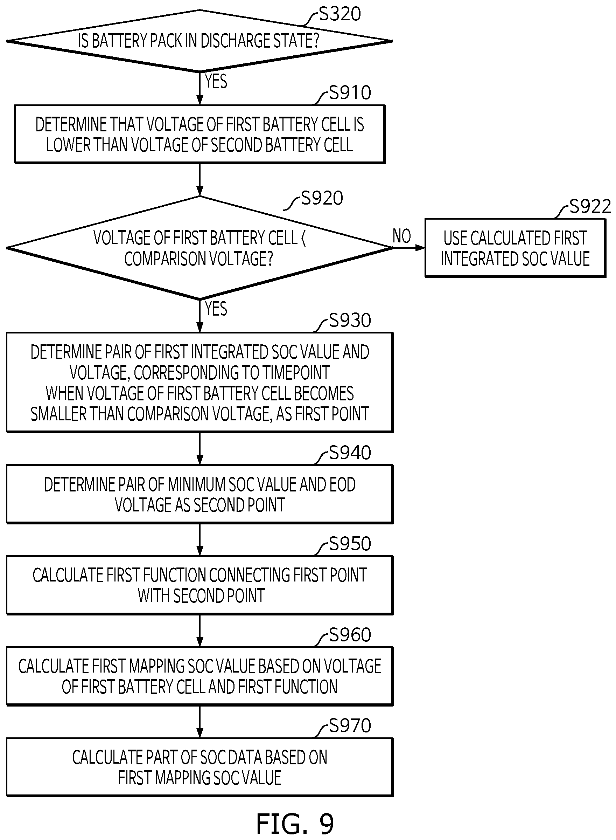

The function mapping unit 240 may determine at least two points to calculate integrated SOC data of the battery pack. For example, the function mapping unit 240 may determine a first point and a second point to calculate integrated SOC data associated with the discharge state of the battery pack. The function mapping unit 240 may calculate a first function which connects the first point with the second point, and may calculate some of the integrated SOC data associated with discharge based on the first function and the voltage of the battery cell. The function mapping unit 240 may determine a third point and a fourth point in order to calculate integrated SOC data associated with the state of charge of the battery pack. The function mapping unit 240 may calculate a second function connecting the third point with the fourth point, and may calculate some of the integrated SOC data associated with charge based on the second function and the current of the battery cell. The specific operation of the function mapping unit 240 is described in detail with reference to FIGS. 9 to 12.

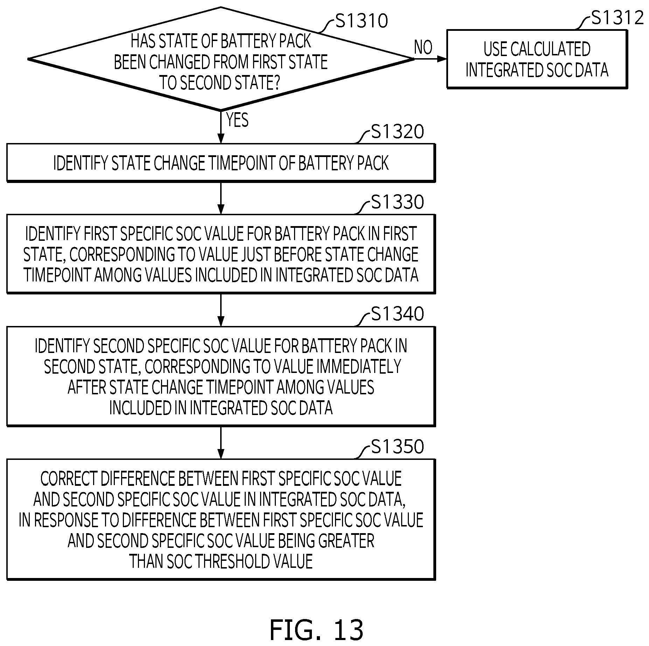

The correction filter application unit 250 may determine the first state of the battery pack as a discharge state, a charge state, or an idle state based on at least one of the voltage of the battery cell and the current of the battery cell. The correction filter application unit 250 may identify the point in time when the state of the battery pack changes in response to the battery pack changing from a first state to a second state different from the first state. The correction filter application unit 250 may apply a correction filter to the integrated SOC data corresponding to the state change timepoint. The specific operation of the correction filter application unit 250 is described in detail with reference to FIGS. 13 to 16.

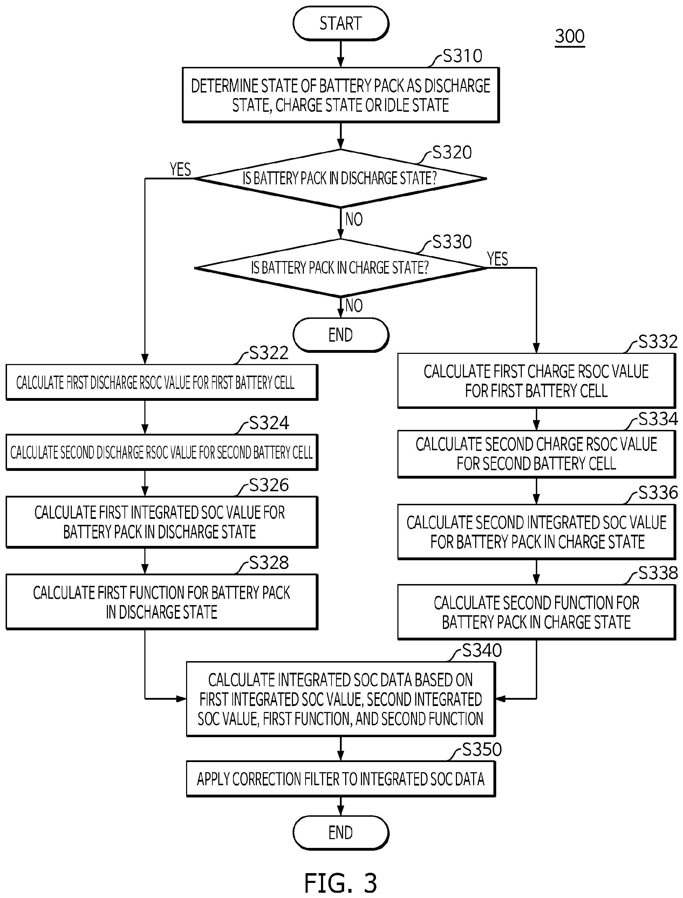

FIG. 3 is a flowchart illustrating an example of a method of operating an electronic device according to an embodiment. FIG. 3 provides an overall explanation of an example of an operation method of an electronic device, and a specific operation method is described later. The operation method of the electronic device may be performed by the integrated SOC calculation unit 138 described in detail with reference to FIGS. 1 and 2.

Hereinafter, an example of a battery pack including a first battery cell and a second battery cell is mainly described. Here, the first battery cell and the second battery cell may be battery cells of the same type or battery cells of different types. The first battery cell and the second battery cell may be connected in parallel with each other. However, embodiments are not limited to this example, and the battery pack may include more battery cells than the first battery cell and the second battery cell.

A battery state determination unit (e.g., battery state determination unit 210 of FIG. 2) may determine the state of the battery pack as a discharge state, a charge state, or an idle state (S310). For example, a battery pack may include a first battery cell and a second battery cell. The battery state determination unit may determine the state of the battery pack, based on the current of the first battery cell and the current of the second battery cell.

A discharge RSOC calculation unit (e.g., a discharge RSOC calculation unit 220 of FIG. 2) may determine whether the battery pack is in a discharge state (S320). The discharge RSOC calculation unit may calculate a first discharge RSOC value for the first battery cell based on the SOC value of the first battery cell in response to the state of the battery pack being determined to be a discharge state (S322). The discharge RSOC calculation unit may calculate a second discharge RSOC value for the second battery cell based on the SOC value of the second battery cell (S324). The discharge RSOC calculation unit may calculate a first integrated SOC value for a battery pack determined to be in a discharge state, based on the first discharge RSOC value and the second discharge RSOC value (S326). Thereafter, the function mapping unit (e.g., the function mapping unit 240 of FIG. 2) may calculate a first function for the battery pack determined to be in a discharge state (S328).

The charge RSOC calculation unit may determine whether the battery pack is in a charge state S330. Referring to FIG. 3, step S330 is illustrated as being performed after step S320, (e.g. in response to a NO determination in step S320) but embodiments are not limited to this example. For example, step S320 may be performed after step S330. In this case, S320 may be performed in response to NO in S330. The method of operation may be terminated in response to NO in S320.

The charge RSOC calculation unit may determine whether the battery pack is in a charge state in response to a determination that the battery pack is not in a discharge state (S330). In response to determining that the battery pack is in a charge state, the charge RSOC calculation unit may calculate a first charge RSOC value for the first battery cell based on the SOC value of the first battery cell (S332). The charge RSOC calculation unit may calculate a second charge RSOC value for the second battery cell based on the SOC value of the second battery cell (S334). The charge RSOC calculation unit may calculate a second integrated SOC value for the battery pack determined to be in a charge state, based on the first charge RSOC value and the second charge RSOC value (S336). Thereafter, the function mapping unit may calculate a second function for the battery pack determined to be in a charge state (S338).

Referring to FIG. 3, it is illustrated that step S324 is performed after step S322, and step S334 is performed after step S332, but embodiments are not limited to this example. For example, step S322 may be performed after step S324, or steps S324 and S322 may be performed simultaneously. Similarly, step S322 may be performed after step S334, or steps S334 and S332 may be performed simultaneously.

The integrated SOC calculation unit may calculate integrated SOC data based on the first integrated SOC value, the second integrated SOC value, the first function, and the second function (S340). For example, for an interval associated with a discharge state, the integrated SOC data may include a first integrated SOC value. For the interval associated with the charge state, the integrated SOC data may include a second integrated SOC value. For the interval associated with the first function, integrated SOC data may be generated based on the first function. For the interval associated with the second function, integrated SOC data may be generated based on the second function. For the remaining intervals (e.g., intervals associated with the idle state), the integrated SOC data may include a third integrated SOC value. For example, the third integrated SOC value may be calculated based on the SOC values of the battery cells included in the battery pack.

In an embodiment, the integrated SOC data may include a third integrated SOC value. Specifically, the third integrated SOC value may be calculated by a first calculation method or a second calculation method. In the first calculation method, the third integrated SOC value may be calculated by averaging the SOC values of a plurality of battery cells included in the battery pack. For example, the third integrated SOC value may be calculated as "the third integrated SOC value = (Qₘₐₓ₁ × SOC₁ + Qₘₐₓ₂ × SOC₂)/(Qₘₐₓ₁ + Qₘₐₓ₂)". Here, Qₘₐₓ₁ may represent the maximum electric capacity of the first battery cell (e.g. the maximum electric capacity immediately after the manufacture of the first battery cell), Qₘₐₓ₂ may represent the maximum electric capacity of the second battery cell (e.g. the maximum electric capacity immediately after the manufacture of the second battery cell), SOC₁ may represent the SOC value of the first battery cell, and SOC₂ may represent the SOC value of the second battery cell. Here, each of Qₘₐₓ₁ and Qₘₐₓ₂ may be determined in advance.

In the second calculation method, the third integrated SOC value may be calculated in the same manner as in the first calculation method. If the third integrated SOC value is less than a first SOC threshold value, the third integrated SOC value may be changed to a minimum value among the SOC values of at least one battery cell. If the third integrated SOC value is greater than or equal to the first SOC threshold value, the third integrated SOC value may be changed to a maximum value among the SOC values of at least one battery cell.

In an embodiment, the battery pack may be determined to be in an idle state. In response, the state of the battery pack may be determined to be not in a discharge state and not in a charge state. The integrated SOC data associated with a battery pack in an idle state may include a third integrated SOC value. That is, the integrated SOC data associated with a battery pack in an idle state may include a third integrated SOC value calculated using the first calculation method or the second calculation method.

A correction filter application unit (e.g., correction filter application unit 250 of FIG. 2) may apply a correction filter to the integrated SOC data (S350). For example, the correction filter application unit may identify a state change timepoint in the battery pack and apply a correction filter to the integrated SOC data corresponding to the state change timepoint. Thereafter, the integrated SOC data with the correction filter applied is transmitted to a processor (e.g., processor 140 of FIG. 1), and the processor may convert the integrated SOC data into the remaining capacity of the battery, and control a display (e.g., display 150 of FIG. 1) to display the remaining capacity of the battery. For example, the remaining capacity of the converted battery is transmitted to a display (e.g., display 150 of FIG. 1), and the display 150 may ultimately display the remaining capacity of the battery.

FIG. 4 is a flowchart for explaining a battery state determination unit according to an embodiment. A battery state determination unit (e.g., a battery state determination unit 210 of FIG. 2) may determine the state of the battery pack as one state among a discharge state, a charge state, and an idle state based on at least one of the current of the first battery cell or the current of the second battery cell (S310).

The current of a battery cell may refer to the current flowing through the battery cell (e.g. the current flowing from or to a terminal of the battery cell). Hereinafter, when the current of a battery cell (e.g., a first battery cell or a second battery cell) is less than 0, the current flowing in the battery cell may correspond to the discharge direction (e.g. current flowing from a positive terminal of the battery cell). When the current of a battery cell (e.g., a first battery cell or a second battery cell) is greater than 0, the current flowing in the battery cell may correspond to the charge direction (e.g. current flowing to the positive terminal of the battery cell). When the current of a battery cell (e.g., a first battery cell or a second battery cell) is 0, the battery cell may be idle. However, embodiments not limited to this example, and the sign of the current and the direction of charge and discharge may be opposite to those described above.

In an embodiment, the battery state determination unit may determine whether the current of the first battery cell is less than 0 and whether the current of the second battery cell is less than 0 (S410). In response to determining that the current of the first battery cell is less than 0 and the current of the second battery cell is less than 0, the battery state determination unit may determine the state of the battery pack as a discharge state (S412).

In an embodiment, the battery state determination unit may determine whether the current of the first battery cell is greater than 0 and whether the current of the second battery cell is greater than 0 in response to determining that the current of the first battery cell is not less than 0 or that the current of the second battery cell is not less than 0 (S420). In response to determining that the current of the first battery cell is greater than 0 and the current of the second battery cell is greater than 0, the battery state determination unit may determine the state of the battery pack as a charge state (S422). The battery state determination unit may determine the state of the battery pack as an idle state in response to determining that the current of the first battery cell is not greater than 0 or that the current of the second battery cell is not greater than 0 (S430).

Referring to FIG. 4, it is illustrated that step S420 is performed after step S410, but embodiments are not limited to this example. For example, step S410 may be performed after step S420. In this case, S410 may be performed in response to NO in S420. Additionally, in response to NO in S410, S430 may be performed. Alternatively, steps S410 and S420 may be performed in parallel (e.g. simultaneously). Step S430 may be performed in response to NO in both of S410 and S420.

FIG. 5 is a flowchart for explaining a discharge RSOC calculation unit according to an embodiment. A battery state determination unit (e.g., battery state determination unit 210 of FIG. 2) may determine the state of the battery pack as a discharge state. A discharge RSOC calculation unit (e.g., discharge RSOC calculation unit 220 of FIG. 2) may determine whether the battery pack is in a discharge state (S320).

Referring to FIG. 5, in the first battery cell and the second battery cell included in the battery pack, the voltage of the first battery cell may be lower than the voltage of the second battery cell. For example, the voltage of the first battery cell sensed at a point in time may be lower than the voltage of the second battery cell sensed at the point in time. In some embodiments, the design of the first battery cell may be different than a design of the second battery cell and, because the design of the first battery cell is different from the design of the second battery cell, the sensed voltage of the first battery cell may always be lower than the sensed voltage of the second battery cell. In this case, the discharge RSOC calculation unit may determine that the voltage of the first battery cell is lower than the voltage of the second battery cell in response to the state of the battery pack being determined to be a discharge state (S510).

The discharge RSOC calculation unit may compare the voltage of the first battery cell with an end of discharge (EOD) voltage (S520). Here, the EOD may represent a target point at which discharge of a battery cell or battery pack is desired to end. EOD may be determined by various criteria. For example, if the voltage of a battery cell (e.g., a first battery cell or a second battery cell) becomes lower than a threshold EOD voltage, an EOD may be set to terminate the discharge for the battery cell. For example, when the voltage of the first battery cell, which is lower than the voltage of the second battery cell, becomes lower than a threshold EOD voltage, an EOD may be set to terminate discharge for a battery pack including the first battery cell and the second battery cell. The criteria may be predetermined. The threshold EOD voltage may be predetermined.

The discharge RSOC calculation unit may calculate the SOC value of the EOD for the battery cell based on the SOC value of the battery cell corresponding to the point in time when the voltage of the first battery cell becomes lower than the EOD voltage (S530). Specifically, the discharge RSOC calculation unit may calculate the SOC value of the first EOD for the first battery cell in response to determining that the voltage of the first battery cell is less than the EOD voltage. The discharge RSOC calculation unit may calculate the SOC value of the second EOD for the second battery cell in response to determining that the voltage of the first battery cell is less than the EOD voltage.

For example, in a battery pack in a discharge state, the voltage of the sensed first battery cell may decrease. The discharge RSOC calculation unit may calculate the SOC value of the first battery cell corresponding to the point in time when the voltage of the first battery cell becomes lower than the EOD voltage, as the SOC value of the first EOD. The discharge RSOC calculation unit may calculate the SOC value of the second battery cell corresponding to the point in time when the voltage of the first battery cell becomes lower than the EOD voltage, as the SOC value of the second EOD.

Thereafter, the discharge RSOC calculation unit may calculate the discharge RSOC value based on the SOC value of the EOD and the SOC value of the battery cell (S540). For example, the first discharge RSOC value may be calculated as "first discharge RSOC = (SOC₁ - SOC_{EOD1})/(1- SOC_{EOD1})". Here, SOC₁ may be the SOC value of the first battery cell, and SOC_{EOD1} may be the SOC value of the first EOD. The second discharge RSOC value may be calculated as "second discharge RSOC = (SOC₂ - SOC_{EOD2})/(1- SOC_{EOD2})". Here, SOC2 may be the SOC value of the second battery cell, and SOC_{EOD2} may be the SOC value of the second EOD.

The discharge RSOC calculation unit may calculate a first integrated SOC value for a battery pack determined to be in a discharge state based on the first discharge RSOC value and the second discharge RSOC value (e.g., S326 of FIG. 3). For example, the first integrated SOC value may be one of the values between the first discharge RSOC value and the second discharge RSOC value. For example, the first integrated SOC value may be an average or median of the first discharge RSOC value and the second discharge RSOC value.

FIG. 6 is a graph for explaining discharge RSOC values according to an embodiment. A battery pack in a discharge state may include a first battery cell and a second battery cell. A first graph 600 may represent the voltage of the first battery cell over time and the voltage of the second battery cell over time. A second graph 650 may represent the SOC value of the first battery cell over time and the SOC value of the second battery cell over time. The second graph 650 may also represent the discharge RSOC value for the first battery cell over time and the discharge RSOC value for the second battery cell over time. Here, the discharge RSOC value for the first battery cell is the first discharge RSOC value and may be calculated using the method for calculating the first discharge RSOC value described with reference to FIG. 5. Similarly, the discharge RSOC value for the second battery cell is the second discharge RSOC value may be calculated using the method for calculating the second discharge RSOC value described with reference to FIG. 5.

The first graph 600 and the second graph 650 may represent the EOD point (EOD2) of the second battery cell. Referring to FIG. 6, the EOD voltage is approximately 3.3 V. The point at which the voltage of the second battery cell becomes lower than the EOD voltage may be the EOD point EOD2 of the second battery cell.

In an embodiment, the voltage of the second battery cell may be lower than the voltage of the first battery cell. For example, due to differences in the design of battery cells, differences in the aging of battery cells, etc., the voltage of a second battery cell disposed within the same battery pack may be lower than the voltage of the first battery cell. In this case, the point at which the voltage of the second battery cell becomes lower than the EOD voltage may be the EOD point of the battery pack. Referring to FIG. 6, the EOD point of the battery pack may be identical or substantially identical to the EOD point EOD2 of the second battery cell.

Referring to FIG. 6, the first discharge RSOC value and the second discharge RSOC value may be 0% or close to 0% at the EOD point of the battery pack. A first integrated SOC value for a battery pack determined to be in a discharge state is generated based on the first discharge RSOC value and the second discharge RSOC value, and the first integrated SOC value may be 0% or close to 0%. The integrated SOC data includes a first integrated SOC value, and the integrated SOC data may be converted into a remaining capacity of the battery by a processor (e.g., processor 140 of FIG. 1). The remaining battery capacity may be 0% or close to 0% at the EOD point of the battery pack, which is the target point where the discharge of the battery pack is intended to end. The remaining battery capacity may be 0% or close to 0% and be shown on a display (e.g., the display 150 of FIG. 1) at the EOD point of the battery pack.

As described above, the remaining battery capacity may be displayed as approximately 0% at a point in time when discharge of the battery pack or battery cells needs to be stopped. Accordingly, the user may intuitively understand the remaining power capacity of their electronic devices.

FIG. 7 is a flowchart for explaining a charge RSOC calculation unit according to an embodiment. A battery state determination unit (e.g., the battery state determination unit 210 of FIG. 2) may determine the state of the battery pack as a charge state. The charge RSOC calculation unit (e.g., the charge RSOC calculation unit 230 of FIG. 2) may determine whether the battery pack is in a charge state (S330).

In an embodiment, the charge RSOC calculation unit may determine that the voltage of the battery pack is greater than or equal to an end of charge (EOC) voltage (S710). The voltage of the battery pack may be calculated based on at least one of the voltage of the first battery cell and the voltage of the second battery cell. For example, the first battery cell and the second battery cell are connected in parallel with each other, and the voltage of the battery pack may be equal to or substantially equal to the voltage of the first battery cell or the voltage of the second battery cell.

The EOC may indicate a target point at which charging of a battery cell or battery pack is desired to end. The EOC may be determined by various criteria. For example, if the voltage of a battery pack is greater than or equal to a threshold EOC voltage, an EOC may be set to terminate charging for the battery pack or change the charging method. For example, if the voltage of the battery pack is lower than the EOC voltage, the battery pack may be charged in a constant current (CC) manner. If the voltage of the battery pack is greater than or equal to the EOC voltage, the battery pack may be charged in a constant voltage (CV) manner. CC charging may be a charging mode in which a constant current is applied to the battery pack. During CC charging, even though a constant current is applied to the battery pack, the current applied to each battery cell may vary (e.g. the distribution of the constant current between the battery cells may vary). CV charging may be a charging mode in which a constant voltage is applied (e.g. maintained across the battery cell(s)). That is, in a battery pack that is in a charge state, if the voltage of the battery pack is lower than the EOC voltage, the battery pack is charged in the CC mode, and in response to determining that the voltage of the battery pack is greater than or equal to the EOC voltage, the charging mode of the battery pack may be changed from the CC mode to the CV mode. Changing the charging mode of the battery pack may be performed by an MCU included in a fuel gauge chip (e.g., the fuel gauge chip 130 of FIG. 1) or a processor (e.g., the processor 140 of FIG. 1). The various criteria may be predetermined. The threshold EOC voltage may be predetermined.

The charge RSOC calculation unit may compare the current of a battery cell (e.g., a first battery cell or a second battery cell) with the EOC current (S720). The EOC current may be predetermined. For example, the EOC current may be determined as a ratio calculated based on the current of a battery cell measured at the point in time when the charging mode of the battery pack is changed (e.g., the point in time when the charging mode is changed from a constant current (CC) mode to constant voltage (CV) mode). For example, the EOC current may be represented by the C-rate. The C-rate of a battery pack or battery cell may be a measurement of the current at which the battery pack or battery cell is charged or discharged. For instance, 1C may represent a current applied during a constant current (CC) mode of charging.

The charge RSOC calculation unit may calculate the SOC value of the EOC for the battery cell based on the SOC value of the battery cell corresponding to the point in time when the current of the battery cell becomes less than the EOC current (S730). For example, the charge RSOC calculation unit may compare the current of the first battery cell with the EOC current. In a battery pack charged in the CV mode, the current of the sensed first battery cell may decrease. The charge RSOC calculation unit may calculate a SOC value of the first EOC for the first battery cell in response to determining that the current of the first battery cell is less than the EOC current. The charge RSOC calculation unit may calculate the SOC value of the first battery cell corresponding to the point in time when the current of the first battery cell becomes less than the EOC current, as a first recording SOC. The SOC value of the first EOC may be calculated as "SOC value of first EOC = 1 - first recording SOC".

The charge RSOC calculation unit may compare the current of the second battery cell with the EOC current. In a battery pack charged in the CV mode, the current of the sensed second battery cell may decrease. The charge RSOC calculation unit may calculate a SOC value of the second EOC for the second battery cell in response to determining that the current of the second battery cell is less than the EOC current. The charge RSOC calculation unit may calculate the SOC value of the second battery cell corresponding to the point in time when the current of the second battery cell becomes less than the EOC current, as the second recording SOC. The SOC value of the second EOC may be calculated as "SOC value of second EOC = 1 - second recording SOC".

Thereafter, the charge RSOC calculation unit may calculate the charge RSOC value based on the SOC value of the EOC and the SOC value of the battery cell (S740). For example, the first charge RSOC value may be calculated as "first charge RSOC = SOC₁/(1-SOC_{EOC1})". Here, SOC₁ may be the SOC value of the first battery cell, and SOC_{EOC1} may be the SOC value of the first EOC. The second charge RSOC value may be calculated as "second charge RSOC = SOC₂/(1-SOC_{EOC2})". Here, SOC₂ may be the SOC value of the second battery cell, and SOC_{EOC2} may be the SOC value of the second EOC.

The charge RSOC calculation unit may calculate a second integrated SOC value for a battery pack determined to be in a charge state based on the first charge RSOC value and the second charge RSOC value (e.g., S336 of FIG. 3). In one example, the second integrated SOC value may be one of the values between the first charge RSOC value and the second charge RSOC value. In one example, the second integrated SOC value may be a smaller value among the first charge RSOC value and the second charge RSOC value.

FIG. 8 is a graph for explaining a charge RSOC value according to an embodiment. A battery pack in a charge state may include a first battery cell and a second battery cell. The first graph 800 may represent the current of the first battery cell over time and the current of the second battery cell over time. The second graph 850 may represent the SOC value of the first battery cell and the SOC value of the second battery cell over time. The second graph 850 may also represent the time-dependent charge RSOC value for the first battery cell and the time-dependent charge RSOC value for the second battery cell. Here, the charge RSOC value for the first battery cell may be calculated as the first charge RSOC value using the method for calculating the first charge RSOC value described with reference to FIG. 7. Similarly, the charge RSOC value for the second battery cell may be calculated as the second charge RSOC value using the method for calculating the second charge RSOC value described with reference to FIG. 7.

The battery pack may be charged in the CC mode. In response to a battery pack voltage becoming greater than or equal to the EOC voltage, the charging mode of the battery pack may be changed from CC mode to CV mode. Accordingly, the charging current of the battery pack may be reduced. Referring to FIG. 8, the charging mode change point (CCCV) of the battery pack may be displayed as the EOC point of the battery pack.

The first graph 800 and the second graph 850 may represent the EOC point EOC1 of the first battery cell and the EOC point EOC2 of the second battery cell. Referring to FIG. 8, the EOC current is about 0.1 C (i.e., 10% of the current according to the CC mode). The point at which the current of the first battery cell becomes lower than the EOC current (approximately 0.1 A) may be the EOC point EOC1 of the first battery cell. The point at which the current of the second battery cell becomes lower than the EOC current (approximately 0.2 A) may be the EOC point EOC2 of the second battery cell.

Referring to FIG. 8, the first charge RSOC value may be 100% or close to 100% at the EOC point of the first battery cell. The second charge RSOC value may be 100% or close to 100% at the EOC point of the second battery cell. A second integrated SOC value for the battery pack determined to be in a charge state is generated based on the first charge ROSC value and the second charge RSOC value, and the second integrated SOC value may be 100% or close to 100%. The integrated SOC data includes a second integrated SOC value, and the integrated SOC data may be converted into a remaining capacity of the battery by a processor (e.g., the processor 140 of FIG. 1). The remaining battery capacity may be 100% or close to 100% at the EOC point of a battery cell, which is the target point where charging of the battery cell is desired to end. The remaining battery capacity may be 100% or close to 100% and be shown on a display (e.g., the display 150 of FIG. 1) at the EOC point of the battery pack.

As described above, the remaining battery capacity may be displayed as approximately 100% at a point where charging of the battery pack or battery cells needs to be stopped. Accordingly, the user may intuitively understand the remaining power capacity of their electronic devices.

FIG. 9 is a flowchart for explaining a function mapping unit according to an embodiment. A battery state determination unit (e.g., the battery state determination unit 210 of FIG. 2) may determine the state of the battery pack as a discharge state. The function mapping unit (e.g., the function mapping unit 240 of FIG. 2) may determine whether the battery pack is in a discharge state (S320).

In an embodiment, in the first battery cell and the second battery cell included in the battery pack, the voltage of the first battery cell may be lower than the voltage of the second battery cell. In this case, the function mapping unit may determine that the voltage of the first battery cell is lower than the voltage of the second battery cell in response to the state of the battery pack being determined to be a discharge state (S910).

Thereafter, the function mapping unit may compare the voltage of the first battery cell with a comparison voltage (S920). The function mapping unit may determine whether the voltage of the first battery cell is less than the comparison voltage. Here, the comparison voltage may be a value that is obtained by adding a specific voltage (e.g. an offset voltage) to the EOD voltage. The function mapping unit may use the calculated first integrated SOC value as integrated SOC data in response to the voltage of the first battery cell being greater than or equal the comparison voltage (S922). Here, the first integrated SOC value may be calculated by the discharge RSOC calculation unit described with reference to FIG. 5.

The function mapping unit may determine a pair of a voltage and a first integrated SOC value corresponding to a point in time when the voltage of the first battery cell becomes lower than the comparison voltage, as a first point (S930). The function mapping unit may determine the first point in response to the voltage of the first battery cell being less than the comparison voltage. In one example, the first point may be expressed as (the first integrated SOC value corresponding to the point in time when the voltage of the first battery cell becomes less than the comparison voltage, a voltage) in (SOC, voltage) coordinates.

The function mapping unit may determine a pair of the minimum value of SOC and the EOD voltage as the second point (S940). In this embodiment, the minimum value of SOC may be 0%. That is, the second point may be expressed as (minimum value of SOC, EOD voltage) in the (SOC, voltage) coordinates.

Thereafter, the function mapping unit may calculate a first function connecting the first point with the second point. The first function may include various functions connecting the first point with the second point. For example, the first function may include a polynomial function, a logarithmic function, an exponential function, etc. that connects the first point with the second point. For instance, the first function may be an interpolation function.

The function mapping unit may calculate a first mapping SOC value based on the voltage of the first battery cell and the first function (S960). For example, the function mapping unit may receive information about the voltage of the first battery cell measured by a sensing device (e.g., the sensing device 120 of FIG. 1). The function mapping unit may calculate the first mapping SOC value by inputting the voltage of the first battery cell measured to the first function. That is, the first mapping SOC value may correspond to the voltage of the first battery cell in the first function.

The function mapping unit may calculate part of the integrated SOC data based on the first mapping SOC value (S970). For example, the integrated SOC data may include a first mapping SOC value instead of a first integrated SOC value corresponding to a portion between a first point and a second point. In this case, the calculation associated with the first integrated SOC value corresponding to a portion between the first point and the second point may not be performed.

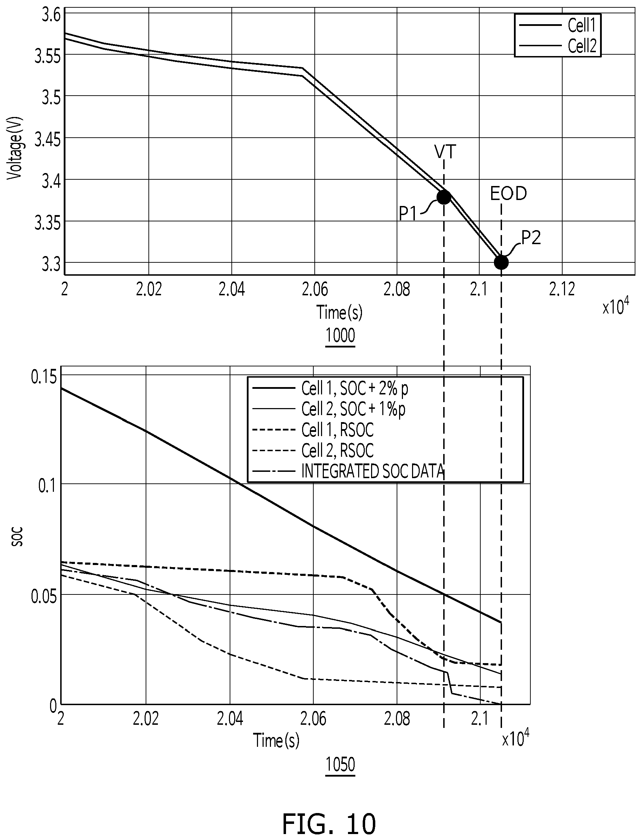

FIG. 10 is a graph for explaining a first mapping SOC value according to an embodiment. A battery pack in a discharge state may include a first battery cell and a second battery cell. The first graph 1000 may represent the voltage of the first battery cell over time and the voltage of the second battery cell over time. The second graph 1050 may represent the SOC value of the first battery cell over time and the SOC value of the second battery cell over time. Here, the SOC value may be a value that is obtained by adding an estimation error. For example, the SOC value for the first battery cell may be a value that is obtained by adding a value calculated by an SOC calculation unit (e.g., the SOC calculation unit 136 of FIG. 1) to an error of about 2%. The SOC value for the second battery cell may be a value that is obtained by adding an error of about 1% to the value calculated by the SOC calculation unit.

The second graph 1050 may represent the discharge RSOC value for the first battery cell over time and the discharge RSOC value for the second battery cell over time. The second graph 1050 may represent part of the integrated SOC data. Here, the discharge RSOC value for the first battery cell is the first discharge RSOC value and may be calculated using the method for calculating the first discharge RSOC value described with reference to FIG. 5. Similarly, the discharge RSOC value for the second battery cell is the second discharge RSOC value may be calculated using the method for calculating the second discharge RSOC value described with reference to FIG. 5. The integrated SOC data may include the first integrated SOC value described with reference to FIG. 5 and the first mapping SOC value described with reference to FIG. 9.

Referring to FIG. 10, the voltage of the second battery cell may be lower than the voltage of the first battery cell. For example, the voltage of a second battery cell disposed within the same battery pack may be lower than the voltage of the first battery cell due to differences in battery cell design, aging rates of battery cells, etc. In this case, the point at which the voltage of the second battery cell becomes lower than the EOD voltage may be the EOD point of the battery pack. Referring to FIG. 10, the end of discharge point EOD of the battery pack may be the same as or substantially the same as the EOD point of the second battery cell.

The function mapping unit may determine a pair of a voltage and a SOC value of the second battery cell corresponding to a point in time VT when the voltage of the second battery cell becomes less than the comparison voltage, as a first point P1. The function mapping unit may determine a pair of the minimum value of SOC and EOD voltage, as the second point P2. Referring to FIG. 10, the EOD voltage may be about 3.3 V, and the comparison voltage may be about 3.38 V.

In a battery pack in a discharge state, the integrated SOC data may include the first integrated SOC value until the point in time VT when the voltage of the second battery cell becomes less than the comparison voltage. The integrated SOC data may include first mapping SOC values from the point in time VT when the voltage of the second battery cell becomes less than the comparison voltage until the end of device EOD point of the battery pack.

Referring to FIG. 10, at the EOD point of the battery pack, the SOC value of the first battery cell, the SOC value of the second battery cell, the first discharge RSOC value, and the second discharge RSOC value may be slightly greater than 0%. In contrast, at the EOD point of the battery pack, the integrated SOC data may be at or close to 0%. The integrated SOC data may be converted into a remaining battery capacity by a processor (e.g., the processor 140 of FIG. 1). At the EOD point of the battery pack, which is the target point where the discharge of the battery pack is intended to end, the remaining battery capacity may be 0% or close to 0%. At the EOD point of the battery pack, the remaining battery capacity may be 0% or close to 0% and be indicated on a display (e.g., the display 150 of FIG. 1).

As described above, the battery may show approximately 0% remaining charge at a point where discharge of the battery pack or battery cells needs to be stopped. Accordingly, the user may intuitively understand the remaining power capacity of their electronic devices.

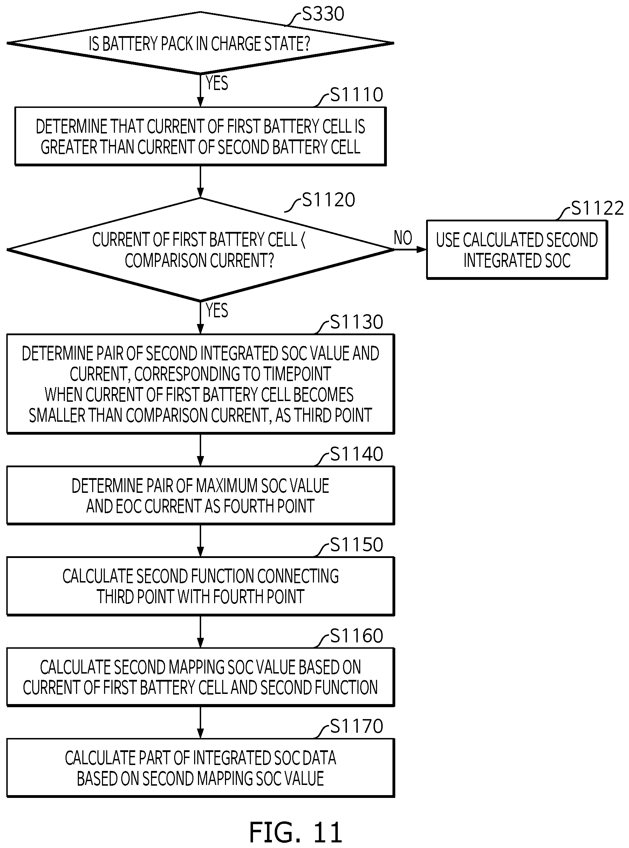

FIG. 11 is a flowchart for explaining a function mapping unit according to an embodiment. A battery state determination unit (e.g., the battery state determination unit 210 of FIG. 2) may determine the state of the battery pack as a charge state. The function mapping unit (e.g., the function mapping unit 240 of FIG. 2) may determine whether the battery pack is in a charge state (S330).

In an embodiment, among the first battery cell and the second battery cell included in the battery pack, the current of the first battery cell may be greater than the current of the second battery cell. For example, in some cases the design of the first battery cell may be different than the design of the second battery cell and, the current of the first battery cell may always be greater than the current of the second battery cell due to the difference in the battery cell design. In this case, the function mapping unit may determine that the current of the first battery cell is greater than the current of the second battery cell in response to the state of the battery pack being determined to be a charge state (S1110).

Thereafter, the function mapping unit may compare the current of the first battery cell with a comparison current (S1120). Here, the comparison current may be a value that is obtained by adding the EOC current to a specific current (e.g. a predefined current). For instance, the comparison current may be equal to the EOC current added to an offset current. The function mapping unit may use the calculated second integrated SOC value as integrated SOC data in response to the current of the first battery cell being greater than or equal to the comparison current (S1122). Here, the second integrated SOC value may be calculated by the charge RSOC calculation unit described with reference to FIG. 7.

The function mapping unit may determine a pair of a current and a second integrated SOC value corresponding to a point in time when the current of the first battery cell becomes less than the comparison current, as a third point (S1130). The function mapping unit may determine the third point in response to the current of the first battery cell being less than the comparison current. That is, the third point may be expressed as (the second integrated SOC value corresponding to the point in time when the current of the first battery cell becomes less than the comparison current, the current) in the (SOC, current) coordinates.

The function mapping unit may determine a pair of the maximum value of SOC and EOC current, as the fourth point (S1140). In this embodiment, the maximum value of SOC may be 0%. That is, the fourth point may be expressed as (the maximum value of SOC, EOC current) in the (SOC, current) coordinates.

Afterwards, the function mapping unit may calculate a second function connecting the third point with the fourth point. The second function may include various functions connecting the third point with the fourth point. For example, the second function may include a polynomial function, a logarithmic function, an exponential function, etc. that connects the third with fourth points. For example, the second function may be an interpolation function.

The function mapping unit may calculate a second mapping SOC value based on the current of the first battery cell and the second function (S1160). For example, the function mapping unit may receive information about the current of the first battery cell measured by a sensing device (e.g., the sensing device 120 of FIG. 1). The function mapping unit may calculate the second mapping SOC value by inputting the measured current of the first battery cell to the second function. That is, the second mapping SOC value may correspond to the current of the first battery cell in the second function.

The function mapping unit may calculate some of the integrated SOC data based on the second mapping SOC value (S1170). For example, the integrated SOC data may include a second mapping SOC value instead of a second integrated SOC value corresponding to a portion between the third point and the fourth point. In this case, the calculation associated with the second integrated SOC value corresponding to a portion between the third point and the fourth point may not be performed.

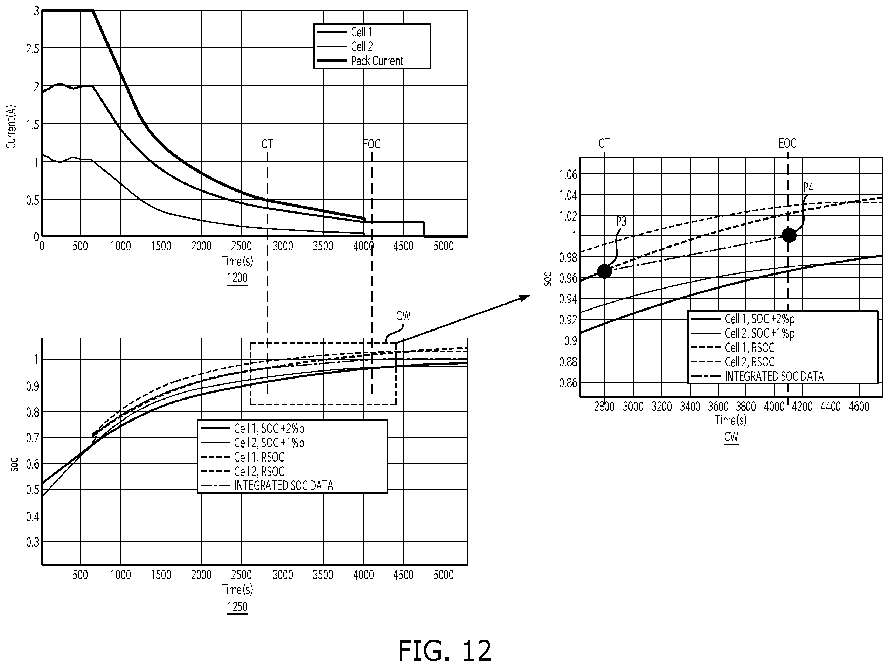

FIG. 12 is a graph for explaining a second mapping SOC value according to an embodiment. A battery pack in a charge state may include a first battery cell and a second battery cell. The first graph 1200 may represent the current of the first battery cell over time and the current of the second battery cell over time. The second graph 1050 may represent the SOC value of the first battery cell over time and the SOC value of the second battery cell over time. Here, the SOC value may be a value that is obtained by adding the estimation error. For example, the SOC value for the first battery cell may be a value that is obtained by adding a value calculated by an SOC calculation unit (e.g., the SOC calculation unit 136 of FIG. 1) to an error of about 2%. The SOC value for the second battery cell may be a value that is obtained by adding an error of about 1% to the value calculated by the SOC calculation unit.

The second graph 1250 may represent a charge RSOC value for the first battery cell over time and a charge RSOC value for the second battery cell over time. The second graph 1250 may represent some of the charge SOC data. Here, the charge RSOC value for the first battery cell is the first charge RSOC value and may be calculated by using the method for calculating the first charge RSOC value described with reference to FIG. 7. Similarly, the charge RSOC value for the second battery cell is the second charge RSOC value and may be calculated by using the method for calculating the second charge RSOC value described with reference to FIG. 7. The integrated SOC data may include a second integrated SOC value described with reference to FIG. 7 and a second mapping SOC value described with reference to FIG. 11.

In an embodiment, the current of the first battery cell may be greater than the current of the second battery cell. For example, the current of a first battery cell disposed within the same battery pack may be greater than the current of a second battery cell due to reasons such as differences in the design of battery cells, differences in the aging degree of battery cells, etc. In this case, the point at which the voltage of the second battery cell becomes greater than the EOC current may be the EOC point of the battery pack.

The function mapping unit may determine a pair of a voltage and a SOC value of the first battery cell corresponding to a point in time CT when the current of the first battery cell becomes less than a comparison current, as a third point P3. The function mapping unit may determine the pair of the maximum value of SOC and EOC current, as the fourth point P4. Referring to the second graph 1250 of FIG. 10, the point in time CT when the current of the first battery cell becomes less than the comparison current, and the EOC point EOC of the battery pack may be displayed in an enlarged shape. Referring to FIG. 10, the EOC current may be about 0.1 C, and the comparison current may be about 0.25 C.

In a battery pack in a discharge state, the integrated SOC data may include a second integrated SOC value until the point in time CT when the current of the first battery cell becomes less than a predetermined current (e.g. the comparison current). The integrated SOC data may include second mapping SOC values from the point in time CT when the voltage of the first battery cell becomes less than the comparison current until the EOC point of the battery pack. The integrated SOC data may include a third integrated SOC value calculated using the first calculation method or the second calculation method described with reference to FIG. 3 until a time point before a point in time when the charging mode of the battery pack is changed (e.g., CCCV of FIG. 8).

Referring to FIG. 12, the SOC value of the first battery cell and the SOC value of the second battery cell at the EOC point of the battery pack may be slightly greater than or less than 100%. The first charge RSOC value and the second charge RSOC value may be slightly greater than or less than 100% at the EOC point of the battery pack. In contrast, the integrated SOC data may be 100% or close to 100% at the EOC point of the battery pack. The integrated SOC data may be converted into a remaining battery capacity by a processor (e.g., processor 140 of FIG. 1). The remaining battery capacity may be 100% or close to 100% at the EOC point of the battery pack, which is the target point where the battery cell charging is intended to end. The remaining battery capacity may be displayed as 100% or close to 100% at the EOC point of the battery pack (e.g., the display 150 of FIG. 1).

As described above, the remaining battery capacity may be displayed as approximately 100% at a point in time when charging of the battery pack or battery cells needs to be stopped. Accordingly, the user may intuitively understand the remaining power capacity of their electronic devices.

FIG. 13 is a flowchart for explaining a correction filter application unit according to an embodiment. A battery state determination unit (e.g., the battery state determination unit 210 of FIG. 2) may determine a first state of the battery pack as a discharge state, a charge state, or an idle state based on at least one of a voltage of a battery cell or a current of a battery cell. The battery state determination unit may determine a second state different from the first state, as the state of the battery pack among a discharge state, a charge state, and an idle state.

A correction filter application unit (e.g., the correction filter application unit 250 of FIG. 2) may determine whether the state of the battery pack changes from a first state to a second state (S1310). The correction filter application unit may use the calculated integrated SOC data as is in response to the battery pack not changing from the first state to the second state (S1312). That is, the correction filter application unit may not apply the correction filter to the integrated SOC data when the state has not changed.

The correction filter application unit may identify a state change timepoint of the battery pack (S1320). For example, the correction filter application unit may identify as the state change timepoint a point in time when the state of the battery pack changes from the first state to the second state. In this case, the correction filter application unit may identify a first specific SOC value corresponding to a value at a point in time just before the state change timepoint among the values included in the integrated SOC data (S1330). The first specific SOC value may be an integrated SOC value for the battery pack in the first state. Similarly, the correction filter application unit may identify a second specific SOC value corresponding to a value at a point in time immediately after a state change timepoint among the values included in the integrated SOC data (S1340). The second specific SOC value may be an integrated SOC value for the battery pack in the second state. Step S1340 is illustrated as being performed after step S1330, but embodiments are not limited to this example. For example, step S1340 may be performed before step S1330 or concurrently with step S1330.

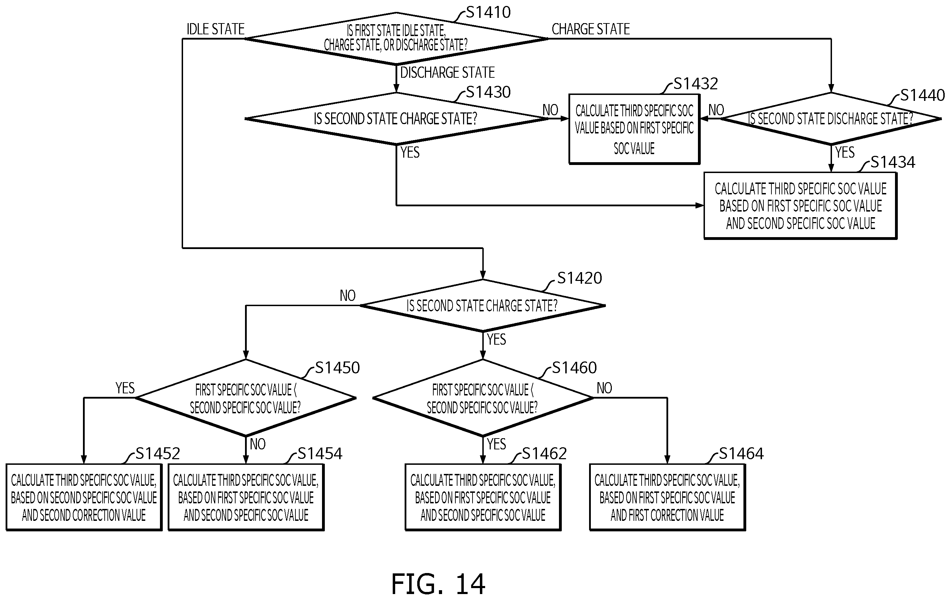

Thereafter, the correction filter application unit may compensate for the difference between the first specific SOC value and the second specific SOC value in the integrated SOC data in response to the difference between the first specific SOC value and the second specific SOC value being greater than the SOC threshold value (S1350). Specifically, the correction filter application unit may calculate a third specific SOC value corresponding to a value at a state change timepoint from the integrated SOC data to correct the difference between the first specific SOC value and the second specific SOC value. The third specific SOC value may be placed after the first specific SOC value and before the second specific SOC value. The method for calculating the third specific SOC value may differ depending on the first state of the battery pack and the second state of the battery pack. The method for calculating the third specific SOC value is described in detail with reference to FIG. 14.

FIG. 14 is a flowchart for explaining a correction filter application unit according to an embodiment. FIG. 14 specifically illustrates a step (S1350) of correcting the difference between the first specific SOC value and the second specific SOC value in the integrated SOC data in FIG. 13.

A correction filter application unit (e.g., the correction filter application unit 250 of FIG. 2) may determine whether the first state of the battery pack is an idle state, a charge state, or a discharge state (S1410). Subsequently or simultaneously, the correction filter application unit may determine whether the second state of the battery pack is an idle state, a charge state, or a discharge state.

In an embodiment, the first state may be determined to be an idle state (S1410, IDLE STATE). In this case, the correction filter application unit may determine whether the second state is a charge state (S1420). If the second state is determined to be a charge state (S1420, YES), the correction filter application unit may compare the first specific SOC value with the second specific SOC value and determine whether the first specific SOC value is less than the second specific SOC value (S1460). Here, the difference between the first specific SOC value and the second specific SOC value may be greater than the SOC threshold value. In response to the first specific SOC value being less than the second specific SOC value (e.g. in response to the second specific SOC value being greater than or equal to the first specific SOC value) (S1460, YES), the correction filter application unit may calculate a third specific SOC value based on the first specific SOC value and the second specific SOC value (S1462). For example, the third specific SOC value may be one of the values between the first specific SOC value and the second specific SOC value. For example, the third specific SOC value may be an average, a weighted average, or a median of the first specific SOC value and the second specific SOC value.

In response to the first specific SOC value not being less than the second specific SOC value (e.g. in response to the second specific SOC value being less than the first specific SOC value) (S1460, NO), the correction filter application unit may calculate a third specific SOC value based on the first specific SOC value and a first correction value (S1464). For example, the third specific SOC value may be a value obtained by adding the first specific SOC value to the first correction value. Here, the first correction value may be determined in advance. For example, the first correction value may be less than the SOC threshold.

The first state may be determined to be an idle state, and the second state may be determined to be a non-charge state (S1420, NO). That is, the second state may be a discharge state. In this case, the correction filter application unit may compare the first specific SOC value with the second specific SOC value and determine whether the first specific SOC value is less than the second specific SOC value (S1450). In response to the first specific SOC value not being less than the second specific SOC value (e.g. in response to the second specific SOC value being less than the first specific SOC value) (S1450, NO), the correction filter application unit may calculate a third specific SOC value based on the first specific SOC value and the second specific SOC value (S1454). For example, the third specific SOC value may be one of the values between the first specific SOC value and the second specific SOC value. For example, the third specific SOC value may be an average, a weighted average, or a median of the first specific SOC value and the second specific SOC value.

In response to the first specific SOC value being less than the second specific SOC value (e.g. in response to the second specific SOC value being greater than or equal to the first specific SOC value) (S1450, YES), the correction filter application unit may calculate a third specific SOC value based on the second specific SOC value and a second correction value (S1452). For example, the third specific SOC value may be the second specific SOC value minus the second correction value. Here, the second correction value may be determined in advance. For example, the second correction value may be less than the SOC threshold.

In an embodiment, the first state may be determined to be a discharge state (S1410, DISCHARGE STATE). In this case, the correction filter application unit may determine whether the second state is a charge state (S1430). If the second state is determined to be a charge state (S1430, YES), the correction filter application unit may calculate a third specific SOC value based on the first specific SOC value and the second specific SOC value (S1434). For example, the third specific SOC value may be one of the values between the first specific SOC value and the second specific SOC value. For example, the third specific SOC value may be an average, a weighted average, or a median of the first specific SOC value and the second specific SOC value.

The first state may be determined to be a discharge state, and the second state may be determined to be a non-charge state (S1430, NO). That is, the second state may be an idle state. In this case, the correction filter application unit may calculate a third specific SOC value based on the first specific SOC value (S1432). For example, the correction filter application unit may determine a third specific SOC value as the same value as the first specific SOC value.

In an embodiment, the first state may be determined to be a charge state (S1410, CHARGE STATE). In this case, the correction filter application unit may determine whether the second state is a discharge state (S1440). If the second state is determined to be a discharge state (S1440, YES), the above-described step S1434 may be performed. If it is determined that the second state is not a discharge state (S1440, NO), that is, if the second state is an idle state, the above-described step S1432 may be performed.

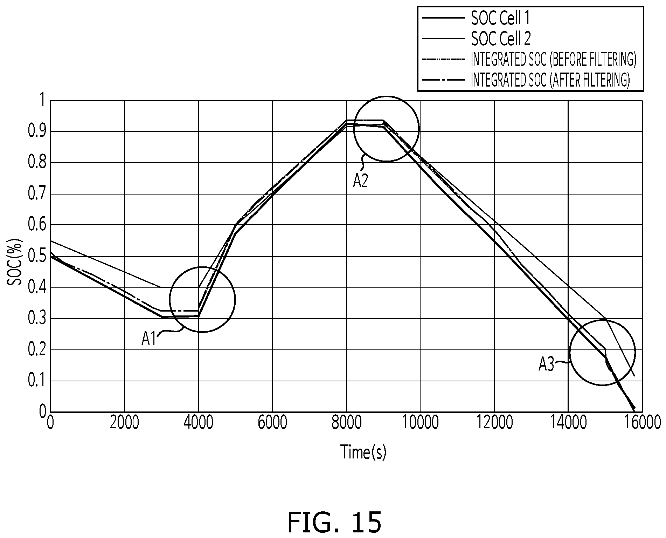

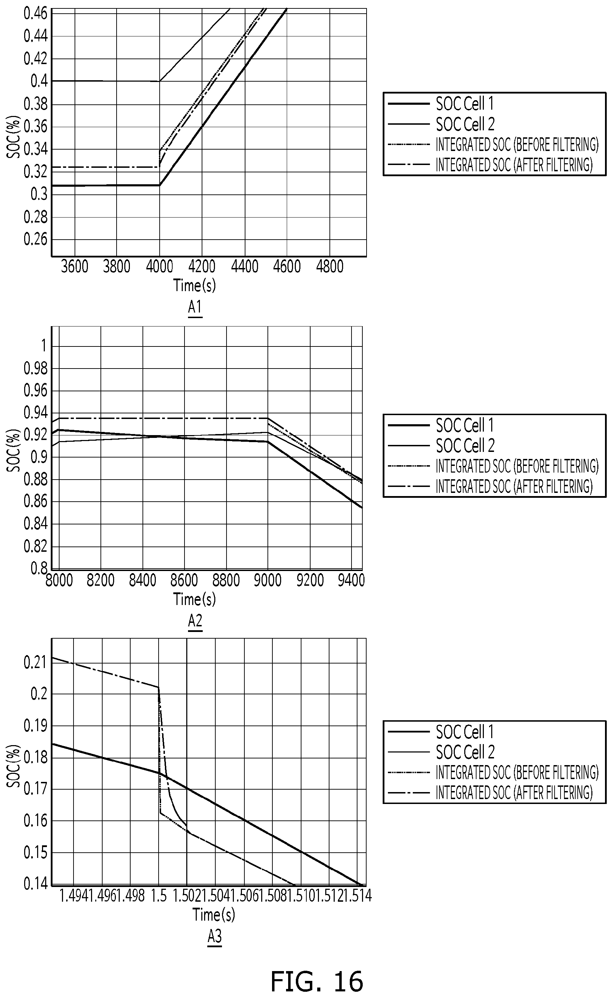

FIGS. 15 and 16 are graphs for explaining integrated SOC data to which a correction filter is applied according to an embodiment. The graph of FIG. 15 may represent a SOC value over time for a first battery cell included in a battery pack and a SOC value over time for a second battery cell included in the battery pack. The graph of FIG. 15 may represent integrated SOC data without a correction filter applied and integrated SOC data with a correction filter applied.

In an embodiment, at the first state change timepoint, the state of the battery pack may change from an idle state to a charge state. At the second state change timepoint, the state of the battery pack may change from an idle state to a discharge state. Referring to FIG. 15, a first area A1 may correspond to the first state change timepoint. The second area A2 may correspond to the second state change timepoint. The third area A3 may be an area surrounding the EOD point of the battery pack.

In FIG. 16, an enlarged graph of the first area A1 to the third area A3 may be illustrated. Referring to the first area A1 of FIG. 16, the integrated SOC data with the correction filter applied may have a relatively gradual increase in the SOC value. On the other hand, integrated SOC data without a correction filter applied may show a steep increase in the SOC value. Referring to the second area A2 of FIG. 16, the integrated SOC data with the correction filter applied may have a relatively gradual increase or decrease in the SOC value. On the other hand, integrated SOC data without a correction filter applied may show a steep increase and decrease in the SOC value. Referring to the third area A3 of FIG. 16, a battery cell or battery pack may show a phenomenon in which the SOC suddenly drops around the EOD point. In this case, the integrated SOC data with the correction filter applied may show a relatively gradual increase or decrease in the SOC value, whereas the integrated SOC data without the correction filter applied may show a steep increase or decrease in the SOC value.

As described above, by applying a correction filter to the integrated SOC data, the values of the integrated SOC data may fluctuate smoothly without exhibiting abrupt changes. Because the remaining battery capacity, which is displayed by converting the integrated SOC data, does not fluctuate drastically, the user may be provided with a high degree of predictability regarding the power supply of their electronic devices.

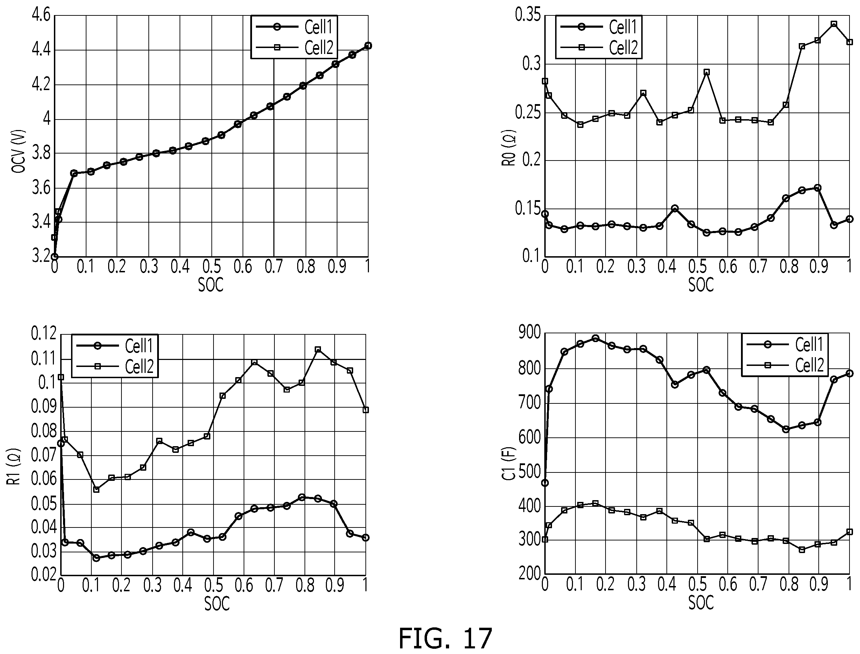

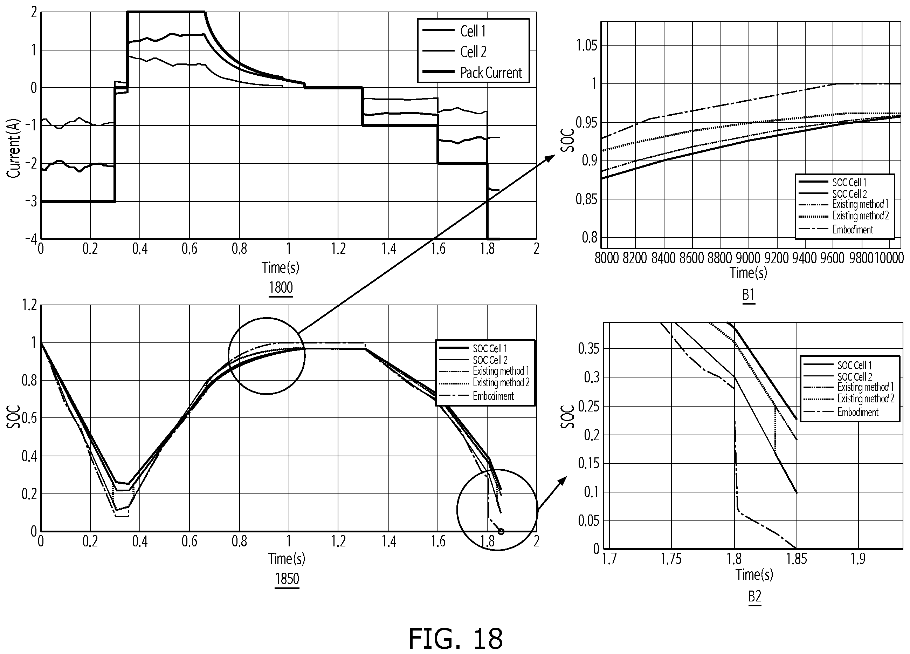

FIG. 17 is a graph showing specification information of a battery pack according to an embodiment. FIG. 18 is a charge/discharge graph of a battery pack according to an embodiment. The battery pack includes a first battery cell and a second battery cell, the first battery cell has a maximum charge amount of about 2321 mAh, and the second battery cell has a maximum charge amount of about 904 mAh. The first battery cell and the second battery cell are different types of battery cells.

FIGS. 17 and 18 show information calculated based on an equivalent circuit model (ECM). FIG. 17 shows information about the open circuit voltage (OCV) according to the SOC value, the electrical resistance according to the SOC value, and the electrical capacity according to the SOC value for a battery cell being charged and discharged (e.g., a first battery cell or a second battery cell).

The first graph 1800 of FIG. 18 represents current over time for a battery pack or battery cell being charged and discharged. The second graph 1850 of FIG. 18 shows the SOC value over time for a battery pack or battery cell being charged and discharged. The second graph 1850 shows the integrated SOC data (according to an embodiment) with the correction filter applied. The second graph 1850 represents integrated SOC values (existing method 1 according to the related art, existing method 2 according to the related art) calculated only by the first calculation method and the second calculation method described with reference to FIG. 3. The X-axis in FIG. 18 shows time of which time scale has been reduced by 10,000 times.

Referring to the first area B1 and the second area B2 of the second graph 1850, it may be seen that the integrated SOC data with the correction filter applied changes gradually. Additionally, the integrated SOC data at the EOD point of the battery pack has a value of approximately 0%, and the integrated SOC data at the EOC point of the battery pack has a value of approximately 100%.

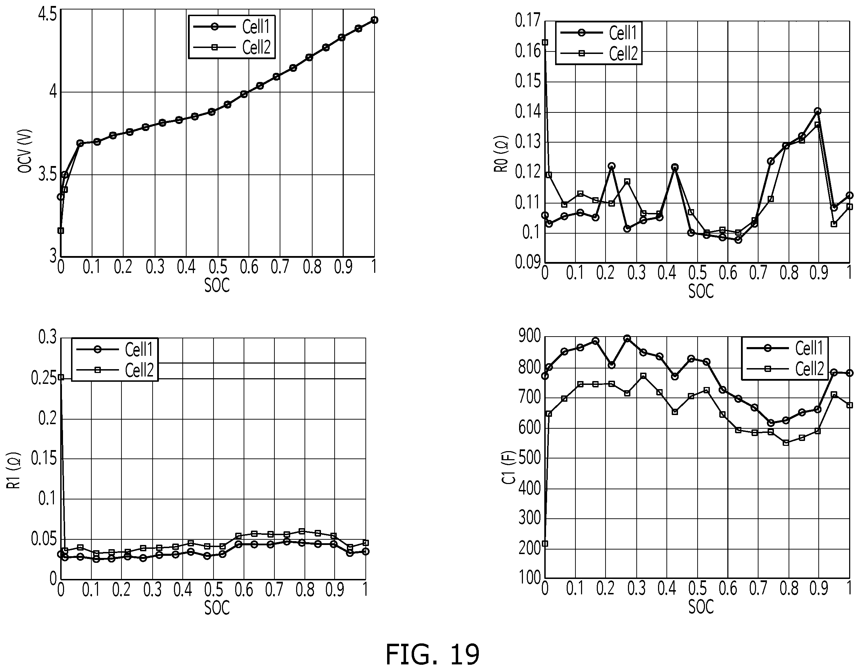

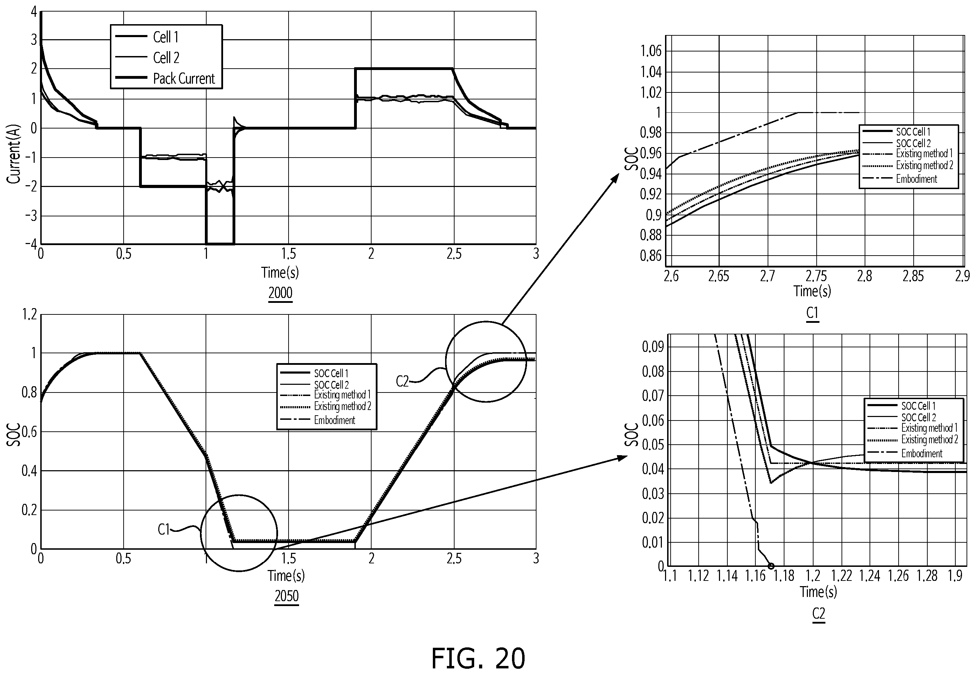

FIG. 19 is a graph showing specification information of a battery pack according to an embodiment. FIG. 20 is a charge/discharge graph of a battery pack according to an embodiment. The battery pack includes a first battery cell and a second battery cell, the first battery cell has a maximum charge amount of about 2315 mAh, and the second battery cell has a maximum charge amount of about 2000 mAh. The first battery cell and the second battery cell are battery cells of the same type or similar type.

FIGS. 19 and 20 show information calculated based on an equivalent circuit model (ECM). FIG. 19 shows information about the open circuit voltage (OCV) according to the SOC value, the electrical resistance according to the SOC value, and the electrical capacity according to the SOC value for a battery cell being charged and discharged (e.g., a first battery cell or a second battery cell).

The first graph 2000 of FIG. 20 represents current over time for a battery pack or battery cell being charged and discharged. The second graph 2050 of FIG. 20 shows the SOC value over time for a battery pack or battery cell being charged and discharged. The second graph 2050 shows the integrated SOC data (according to an embodiment) with the correction filter applied. The second graph 2050 represents integrated SOC values (existing method 1 according to the related art, existing method 2 according to the related art) calculated only by the first calculation method and the second calculation method described with reference to FIG. 3. The X-axis in FIG. 20 shows time of which time scale has been reduced by 10,000 times.

Referring to the first area C1 and the second area C2 of the second graph 2050, it may be seen that the integrated SOC data with the correction filter applied changes gradually. Additionally, the integrated SOC data at the EOD point of the battery pack has a value of approximately 0%, and the integrated SOC data at the EOC point of the battery pack has a value of approximately 100%.

Referring to FIGS. 16 to 20, it may be seen that the operating method of an electronic device according to an embodiment is applicable regardless of whether a plurality of battery cells included in a battery pack are battery cells of the same type or of different types.

While certain embodiments are described referring to a "first battery cell" and a "second battery cell" it will be appreciated that the labelling of the battery cells is simply to distinguish the battery cells from one another, and need not imply any particular arrangement or order of the battery cells. As discussed herein, the first battery cell may be a battery cell that is determined to have a voltage that is less than the voltage of the second battery cell and/or that is determined to have a current that is greater than the current of the second battery cell. Various battery cells may be compared, and a battery cell may be classified as a first battery cell in response to the voltage of the battery cell being determined to be less than the voltage of another battery cell (which may be classified as the second battery cell). For instance, determining that the voltage of the first battery cell is lower than the voltage of the second battery cell may comprise identifying a first battery cell that has a voltage that is lower than a voltage of a second battery cell. In addition or alternatively, various battery cells may be compared, and a battery cell may be classified as a first battery cell in response to the current of the battery cell being determined to be greater than the current of another battery cell (which may be classified as the second battery cell). For instance, determining that the current of the first battery cell is greater than the current of the second battery cell may comprise identifying a first battery cell that has a current that is greater than a current of a second battery cell.

Various steps are explained herein as being performed "when" a certain condition is met. It will be appreciated that a device may be configured to perform these steps "in response" to a determination that the condition is met. Accordingly, a device may be configured to implement all of the steps described herein; however, different steps will be implemented at different times depending on the specific conditions at that time.

Embodiments are set out in the following clauses:
Clause 1. A method of operating an electronic device comprising a battery pack comprising a first battery cell and a second battery cell connected in parallel, the method (e.g. performed by a controller, such as a micro controller unit) comprising:
   calculating a first discharge relative state of charge (RSOC) value for the first battery cell, based on a state of charge (SOC) value of the first battery cell that is calculated based on at least one of a voltage or a current of the first battery cell;
   calculating a second discharge RSOC value for the second battery cell, based on a SOC value of the second battery cell that is calculated based on at least one of a voltage or a current of the second battery cell; and
   calculating integrated SOC data for the battery pack based on the first discharge RSOC value and the second discharge RSOC value.
Clause 2. The method of clause 1, further comprising determining a state of the battery pack as a state among a discharge state, a charge state, and an idle state, based on at least one of the current of the first battery cell, the voltage of the first battery cell, the current of the second battery cell, or the voltage of the second battery cell,
   wherein the integrated SOC data comprises a first integrated SOC value for the battery pack that is determined to be in the discharge state and a second integrated SOC value for the battery pack that is determined to be in the charge state.
Clause 3. The method of clause 2, wherein calculating the first discharge RSOC value comprises:
   determining the state of the battery pack as the discharge state;
   determining that the voltage of the first battery cell is lower than the voltage of the second battery cell;
   comparing the voltage of the first battery cell with an end of discharge (EOD) voltage;
   in response to the voltage of the first battery cell being less than the EOD voltage, calculating a SOC value of a first EOD for the first battery cell, based on the SOC value of the first battery cell that corresponds to a point in time when the voltage of the first battery cell becomes less than the EOD voltage; and
   calculating the first discharge RSOC value, based on the SOC value of the first EOD and the SOC value of the first battery cell.
Clause 4. The method of clause 3, wherein calculating the second discharge RSOC value comprises:
   determining the state of the battery pack as the discharge state;
   determining that the voltage of the first battery cell is lower than the voltage of the second battery cell;
   comparing the voltage of the second battery cell with the EOD voltage;
   in response to the voltage of the first battery cell being less than the EOD voltage, calculating a SOC value of a second EOD for the second battery cell, based on the SOC value of the second battery cell that corresponds to a point in time when the voltage of the first battery cell becomes less than the EOD voltage; and
   calculating the second discharge RSOC value, based on the SOC value of the second EOD and the SOC value of the second battery cell, and
   wherein calculating the integrated SOC data comprises calculating the first integrated SOC value for the battery pack that is determined to be in the discharge state, based on the first discharge RSOC value and the second discharge RSOC value.
Clause 5. The method of any of clauses 2-4, further comprising:
   calculating a first charge RSOC value for the first battery cell, based on the SOC value of the first battery cell; and
   calculating a second charge RSOC value for the second battery cell, based on the SOC value of the second battery cell,
   wherein calculating the integrated SOC data comprises calculating a second integrated SOC value for the battery pack that is determined to be in the charge state, based on the first charge RSOC value and the second charge RSOC value.
Clause 6. The method of clause 5, wherein calculating the first charge RSOC value comprises:
   determining the state of the battery pack as the charge state;
   determining that the voltage of the battery pack is greater than or equal to an end of charge (EOC) voltage;
   comparing the current of the first battery cell with an EOC current;
   in response to the current of the first battery cell being less than the EOC current, calculating a SOC value of a first EOC for the first battery cell, based on the SOC value of the first battery cell that corresponds to a point in time when the current of the first battery cell becomes less than the EOC current; and
   calculating the first charge RSOC value, based on the SOC value of the first EOC and the SOC value of the first battery cell.
Clause 7. The method of clause 6, wherein calculating the second charge RSOC value comprises:
   determining the state of the battery pack as the charge state;
   determining that the voltage of the battery pack is greater than or equal to the EOC voltage;
   comparing the current of the second battery cell with the EOC current;
   in response to the current of the second battery cell being less than the EOC current, calculating a SOC value of a second EOC for the second battery cell, based on the SOC value of the second battery cell that corresponds to a point in time when the current of the second battery cell becomes less than the EOC current; and
   calculating the second charge RSOC value, based on the SOC value of the second EOC and the SOC value of the second battery cell.
Clause 8. The method of clause 6 or clause 7, further comprising, in response to the voltage of the battery pack being greater than or equal to the EOC voltage, changing a charging mode of the battery pack to a constant charging mode at the EOC voltage.
Clause 9. The method of any preceding clause, wherein calculating the integrated SOC data comprises:
   determining the state of the battery pack as a discharge state;
   determining that the voltage of the first battery cell is lower than the voltage of the second battery cell;
   comparing the voltage of the first battery cell with a comparison voltage;
   in response to the voltage of the first battery cell being less than the comparison voltage, determining a pair of a voltage and the SOC value of the first battery cell that corresponds to a point in time when the voltage of the first battery cell becomes less than the comparison voltage, as a first point;
   determining a pair of a minimum value of the SOC and an EOD voltage that corresponds to the minimum value of the SOC, as a second point;
   calculating a first function that connects the first point to the second point based on the first point and the second point; and
   calculating a part of the integrated SOC data based on the first function.
Clause 10. The method of clause 9, wherein the part of the integrated SOC data is calculated based on the voltage of the first battery cell and the first function.
Clause 11. The method of any preceding clause, wherein calculating the integrated SOC data comprises:
   determining the state of the battery pack as a charge state;
   determining that the current of the first battery cell is greater than the current of the second battery cell;
   comparing the current of the first battery cell with a comparison current;
   in response to the current of the first battery cell being less than the comparison current, determining a pair of a current and the SOC value of the first battery cell that corresponds to a point in time when the current of the first battery cell becomes less than the comparison current, as a third point;
   determining a pair of a maximum SOC value of SOC and an EOC current that corresponds to the maximum SOC value, as a fourth point;
   calculating a second function that connects the third point to the fourth point; and
   calculating a part of the integrated SOC data based on the second function.
Clause 12. The method of clause 11, wherein the part of the integrated SOC data is calculated based on the second function and the current of the second battery cell.
Clause 13. The method of any preceding clause, wherein calculating the integrated SOC data comprises:
   determining a first state of the battery pack as a state among a discharge state, a charge state, and an idle state, based on at least one of the current of the first battery cell, the voltage of the first battery cell, the current of the second battery cell, or the voltage of the second battery cell,
   in response to the battery pack changing from the first state to a second state that is different from the first state among the discharge state, the charge state, and the idle state, identifying a state change timepoint of the battery pack at which the first state changes to the second state; and
   applying a correction filter to the integrated SOC data corresponding to the state change timepoint.
Clause 14. The method of clause 13, wherein applying the correction filter comprises:
   identifying a first specific SOC value for the battery pack in the first state, the first specific SOC value corresponding to a point in time just before the state change timepoint among values comprised in the integrated SOC data;
   identifying a second specific SOC value for the battery pack in the second state, the second specific SOC value corresponding to a point in time immediately after the state change timepoint among the values comprised in the integrated SOC data; and
   in response to a difference between the first specific SOC value and the second specific SOC value being greater than a SOC threshold value, correcting the difference between the first specific SOC value and the second specific SOC value in the integrated SOC data.
Clause 15. The method of clause 14, wherein, correcting the difference comprises:
   when the first state is the idle state and the second state is the charge state,
   in response to determining that the second specific SOC value is greater than or equal to the first specific SOC value, calculating a third specific SOC value corresponding to the state change timepoint, based on the first specific SOC value and the second specific SOC value; and
   in response to determining that the second specific SOC value is less than the first specific SOC value, calculating a third specific SOC value based on the first specific SOC value and a first correction value.
Clause 16. The method of clause 14 or clause 15, wherein, correcting the difference comprises:
   when the first state is the idle state and the second state is the discharge state,
   in response to determining that the second specific SOC value is greater than or equal to the first specific SOC value, calculating a third specific SOC value corresponding to the state change timepoint, based on the second specific SOC value and a second correction value; and
   in response to determining that the second specific SOC value is less than the first specific SOC value, calculating the third specific SOC value, based on the first specific SOC value and the second specific SOC value.
Clause 17. The method of any of clauses 14-16, wherein correcting the difference comprises, when the first state is the charge state or the discharge state, and the second state is the idle state, calculating a third specific SOC value corresponding to the state change timepoint based on the first specific SOC value.
Clause 18. The method of any of clauses 14-17, wherein correcting the difference comprises, when the first state is the charge state and the second state is the discharge state, or when the first state is the discharge state and the second state is the charge state, calculating a third specific SOC value corresponding to the state change timepoint based on the first specific SOC value and the second specific SOC value.
Clause 19. An electronic device comprising:
   a battery pack comprising a first battery cell and a second battery cell connected in parallel, the battery pack configured to supply power to the electronic device;
   a sensing device configured to sense at least one of a voltage or a current of the first battery cell and at least one of a voltage or a current of the second battery cell; and
   a microcontroller unit (MCU) configured to implement:
      a state of charge (SOC) calculation unit configured to calculate a SOC value of the first battery cell based on the at least one of the voltage or the current of the first battery cell and calculate a SOC value of the second battery cell based on the at least one of the voltage or the current of the second battery cell; and
      an integrated SOC calculation unit configured to calculate a first discharge state of charge (RSOC) value for the first battery cell based on the SOC value of the first battery cell, calculate a second discharge RSOC value for the second battery cell based on the SOC value of the second battery cell, and calculate integrated SOC data for the battery pack based on the first discharge RSOC value and the second discharge RSOC value.
Clause 20. An electronic device comprising:
   a battery pack comprising a first battery cell and a second battery cell connected in parallel, the battery pack configured to supply power to the electronic device;
   a sensing device configured to sense at least one of a voltage or a current of the first battery cell and at least one of a voltage or a current of the second battery cell;
   a micro controller unit (MCU) configured to implement:
      a state of charge (SOC) calculation unit configured to calculate a SOC value of the first battery cell based on the at least one of the voltage or the current of the first battery cell and calculate a SOC value of the second battery cell based on the at least one of the voltage or the current of the second battery cell; and
      an integrated SOC calculation unit configured to generate integrated SOC data;
   a display; and
   a processor configured to receive the integrated SOC data, convert the integrated SOC data into a remaining battery capacity, and control the display to display the remaining battery capacity,
   wherein the integrated SOC calculation unit is configured to:
      determine a state of the battery pack as one state among a discharge state, a charge state, and an idle state, based on at least one of the current of the first battery cell, the voltage of the first battery cell, the current of the second battery cell, or the voltage of the second battery cell;
      calculate a first discharge state of charge (RSOC) value for the first battery cell, based on the SOC value of the first battery cell;
      calculate a second discharge RSOC value for the second battery cell, based on the SOC value of the second battery cell;
      calculate a first integrated SOC value for the battery pack that is determined to be in the discharge state, the first integrated SOC value being based on the first discharge RSOC value and the second discharge RSOC value;
      calculate a first charge RSOC value for the first battery cell, based on the SOC value of the first battery cell;
      calculate a second charge RSOC value for the second battery cell, based on the SOC value of the second battery cell; and
      calculate a second integrated SOC value for the battery pack that is determined to be in the charge state, the second integrated SOC value being based on the first charge RSOC value and the second charge RSOC value; and
   wherein the integrated SOC calculation unit is configured to generate the integrated SOC data based on the first integrated SOC value and the second integrated SOC value.

While various embodiments have been described with reference to the drawings, it will be apparent to those of ordinary skill in the art that various changes and modifications may be made thereto without departing from the scope of the present disclosure as set forth in the following claims.

## Claims

1. A method of operating an electronic device (10) comprising a battery pack (110) comprising a first battery cell and a second battery cell connected in parallel, the method performed by a micro controller unit and comprising:
calculating a first discharge relative state of charge, RSOC, value for the first battery cell, based on a state of charge, SOC, value of the first battery cell that is calculated based on at least one of a voltage or a current of the first battery cell (S322);
calculating a second discharge RSOC value for the second battery cell, based on a SOC value of the second battery cell that is calculated based on at least one of a voltage or a current of the second battery cell (S324); and
calculating integrated SOC data for the battery pack (110) based on the first discharge RSOC value and the second discharge RSOC value.

2. The method as claimed in claim 1, further comprising determining a state of the battery pack (110) as a state among a discharge state, a charge state, and an idle state, based on at least one of the current of the first battery cell, the voltage of the first battery cell, the current of the second battery cell, or the voltage of the second battery cell (S310),
wherein the integrated SOC data comprises a first integrated SOC value for the battery pack (110) that is determined to be in the discharge state and a second integrated SOC value for the battery pack (110) that is determined to be in the charge state.

3. The method as claimed in claim 2, wherein calculating the first discharge RSOC value (S322) comprises, in response to determining the state of the battery pack (110) as the discharge state (S320):
determining that the voltage of the first battery cell is lower than the voltage of the second battery cell (S510);
comparing the voltage of the first battery cell with an end of discharge, EOD, voltage (S520);
in response to the voltage of the first battery cell being less than the EOD voltage, calculating a SOC value of a first EOD for the first battery cell, based on the SOC value of the first battery cell that corresponds to a point in time when the voltage of the first battery cell becomes less than the EOD voltage; and
calculating the first discharge RSOC value, based on the SOC value of the first EOD and the SOC value of the first battery cell.

4. The method as claimed in claim 3, wherein calculating the second discharge RSOC value (S324) comprises, in response to determining the state of the battery pack (110) as the discharge state (S320):
determining that the voltage of the first battery cell is lower than the voltage of the second battery cell (S510);
in response to the voltage of the first battery cell being less than the EOD voltage, calculating a SOC value of a second EOD for the second battery cell, based on the SOC value of the second battery cell that corresponds to a point in time when the voltage of the first battery cell becomes less than the EOD voltage; and
calculating the second discharge RSOC value, based on the SOC value of the second EOD and the SOC value of the second battery cell, and
wherein calculating the integrated SOC data comprises calculating the first integrated SOC value for the battery pack (110) that is determined to be in the discharge state, based on the first discharge RSOC value and the second discharge RSOC value.

5. The method as claimed in any of claims 2-4, further comprising, in response to determining the state of the battery pack (110) as the charge state (S330):
calculating a first charge RSOC value for the first battery cell, based on the SOC value of the first battery cell (S332); and
calculating a second charge RSOC value for the second battery cell, based on the SOC value of the second battery cell (S334),
wherein calculating the integrated SOC data comprises calculating a second integrated SOC value for the battery pack (110) that is determined to be in the charge state, based on the first charge RSOC value and the second charge RSOC value.

6. The method as claimed in claim 5, wherein calculating the first charge RSOC value (S332) comprises:
determining that the voltage of the battery pack (110) is greater than or equal to an end of charge, EOC, voltage (S710);
comparing the current of the first battery cell with an EOC current;
in response to the current of the first battery cell being less than the EOC current, calculating a SOC value of a first EOC for the first battery cell, based on the SOC value of the first battery cell that corresponds to a point in time when the current of the first battery cell becomes less than the EOC current; and
calculating the first charge RSOC value, based on the SOC value of the first EOC and the SOC value of the first battery cell.

7. The method as claimed in claim 6, wherein calculating the second charge RSOC value (S334) comprises:
determining that the voltage of the battery pack (110) is greater than or equal to the EOC voltage (S710);
comparing the current of the second battery cell with the EOC current;
in response to the current of the second battery cell being less than the EOC current, calculating a SOC value of a second EOC for the second battery cell, based on the SOC value of the second battery cell that corresponds to a point in time when the current of the second battery cell becomes less than the EOC current; and
calculating the second charge RSOC value, based on the SOC value of the second EOC and the SOC value of the second battery cell.

8. The method as claimed in claim 6 or claim 7, further comprising, in response to the voltage of the battery pack (110) being greater than or equal to the EOC voltage, changing a charging mode of the battery pack (110) to a constant voltage charging mode at the EOC voltage.

9. The method as claimed in any preceding claim, wherein calculating the integrated SOC data comprises,
in response to determining the state of the battery pack (110) as a discharge state (S320):
determining that the voltage of the first battery cell is lower than the voltage of the second battery cell (S910);
comparing the voltage of the first battery cell with a comparison voltage (S920);
in response to the voltage of the first battery cell being less than the comparison voltage, determining a pair of a voltage and the SOC value of the first battery cell that corresponds to a point in time when the voltage of the first battery cell becomes less than the comparison voltage, as a first point (S930);
determining a pair of a minimum value of the SOC and an EOD voltage that corresponds to the minimum value of the SOC, as a second point (S940);
calculating a first function that connects the first point to the second point based on the first point and the second point (S950); and
calculating a part of the integrated SOC data based on the first function.

10. The method as claimed in any preceding claim, wherein calculating the integrated SOC data comprises, in response to determining the state of the battery pack (110) as a charge state (S330):
determining that the current of the first battery cell is greater than the current of the second battery cell (S1110);
comparing the current of the first battery cell with a comparison current (S1120);
in response to the current of the first battery cell being less than the comparison current, determining a pair of a current and the SOC value of the first battery cell that corresponds to a point in time when the current of the first battery cell becomes less than the comparison current, as a third point (S1130);
determining a pair of a maximum SOC value of SOC and an EOC current that corresponds to the maximum SOC value, as a fourth point (S1140);
calculating a second function that connects the third point to the fourth point (S1150); and
calculating a part of the integrated SOC data based on the second function.

11. The method as claimed in any preceding claim, wherein calculating the integrated SOC data comprises:
determining a first state of the battery pack (110) as a state among a discharge state, a charge state, and an idle state, based on at least one of the current of the first battery cell, the voltage of the first battery cell, the current of the second battery cell, or the voltage of the second battery cell (S1410),
in response to the battery pack (110) changing from the first state to a second state that is different from the first state among the discharge state, the charge state, and the idle state, identifying a state change timepoint of the battery pack (110) at which the first state changes to the second state (S1320); and
applying a correction filter to the integrated SOC data corresponding to the state change timepoint (S350).

12. The method as claimed in claim 11, wherein applying the correction filter (S350) comprises:
identifying a first specific SOC value for the battery pack (110) in the first state, the first specific SOC value corresponding to a point in time just before the state change timepoint among values comprised in the integrated SOC data (S1330);
identifying a second specific SOC value for the battery pack (110) in the second state, the second specific SOC value corresponding to a point in time immediately after the state change timepoint among the values comprised in the integrated SOC data (S1340); and
in response to a difference between the first specific SOC value and the second specific SOC value being greater than a SOC threshold value, correcting the difference between the first specific SOC value and the second specific SOC value in the integrated SOC data (S1350).

13. The method as claimed in claim 12, wherein, correcting the difference (S1350) comprises, when the first state is the idle state and the second state is the charge state:
in response to determining that the second specific SOC value is greater than or equal to the first specific SOC value, calculating a third specific SOC value corresponding to the state change timepoint, based on the first specific SOC value and the second specific SOC value (S1462); and
in response to determining that the second specific SOC value is less than the first specific SOC value, calculating a third specific SOC value based on the first specific SOC value and a first correction value (S1464).

14. The method as claimed in claim 12 or claim 13, wherein, correcting the difference (S1350) comprises, when the first state is the idle state and the second state is the discharge state:
in response to determining that the second specific SOC value is greater than or equal to the first specific SOC value, calculating a third specific SOC value corresponding to the state change timepoint, based on the second specific SOC value and a second correction value (S1452); and
in response to determining that the second specific SOC value is less than the first specific SOC value, calculating the third specific SOC value, based on the first specific SOC value and the second specific SOC value (S1454).

15. An electronic device (10) comprising:
a battery pack (110) comprising a first battery cell and a second battery cell connected in parallel, the battery pack (110) configured to supply power to the electronic device (10);
a sensing device (120) configured to sense at least one of a voltage or a current of the first battery cell and at least one of a voltage or a current of the second battery cell;
a micro controller unit, MCU, configured to implement:
a state of charge, SOC, calculation unit (136) configured to calculate a SOC value of the first battery cell based on the at least one of the voltage or the current of the first battery cell and calculate a SOC value of the second battery cell based on the at least one of the voltage or the current of the second battery cell; and
an integrated SOC calculation unit (138) configured to generate integrated SOC data;
a display (150); and
a processor (140) configured to receive the integrated SOC data, convert the integrated SOC data into a remaining battery capacity, and control the display to display the remaining battery capacity,
wherein the integrated SOC calculation unit (138) is configured to:
determine a state of the battery pack (110) as one state among a discharge state, a charge state, and an idle state, based on at least one of the current of the first battery cell, the voltage of the first battery cell, the current of the second battery cell, or the voltage of the second battery cell;
in response to the state of the battery pack being a discharge state:
calculate a first discharge relative state of charge, RSOC, value for the first battery cell, based on the SOC value of the first battery cell;
calculate a second discharge relative RSOC value for the second battery cell, based on the SOC value of the second battery cell; and
calculate a first integrated SOC value for the battery pack (110) that is determined to be in the discharge state, the first integrated SOC value being based on the first discharge RSOC value and the second discharge RSOC value; and
in response to the state of the battery pack (110) being a charge state:
calculate a first charge RSOC value for the first battery cell, based on the SOC value of the first battery cell;
calculate a second charge RSOC value for the second battery cell, based on the SOC value of the second battery cell; and
calculate a second integrated SOC value for the battery pack (110) that is determined to be in the charge state, the second integrated SOC value being based on the first charge RSOC value and the second charge RSOC value; and
wherein the integrated SOC calculation unit (138) is configured to generate the integrated SOC data based on the first integrated SOC value and the second integrated SOC value.
